# EUROPÄISCHE PATENTSCHRIFT

(11) **EP 1 230 441 B1**
(45) Veröffentlichungstag und Bekanntmachung des Hinweises auf die Patenterteilung: **01.12.2004**
(21) Anmeldenummer: 00975831.9
(22) Anmeldetag: 05.10.2000
(51) Int. Cl.: C25D 5/00, C25D 7/06, C25F 3/02, H05K 3/24

(54) **VERFAHREN UND VORRICHTUNG ZUM ELEKTROLYTISCHEN BEHANDELN VON ELEKTRISCH GEGENEINANDER ISOLIERTEN, ELEKTRISCH LEITFÄHIGEN STRUKTUREN AUF OBERFLÄCHEN VON ELEKTRISCH ISOLIERENDEM FOLIENMATERIAL SOWIE ANWENDUNGEN DES VERFAHRENS**
METHOD AND DEVICE FOR THE ELECTROLYTIC TREATMENT OF ELECTRICALLY CONDUCTING STRUCTURES WHICH ARE INSULATED FROM EACH OTHER AND POSITIONED ON THE SURFACE OF ELECTRICALLY INSULATING FILM MATERIALS AND USE OF THE METHOD
PROCEDE ET DISPOSITIF DE TRAITEMENT ELECTROLYTIQUE DE STRUCTURES ELECTROCONDUCTRICES ELECTRIQUEMENT ISOLEES L'UNE DE L'AUTRE ET PLACEES SUR LES SURFACES DE FILMS ELECTRIQUEMENT ISOLANTS ET APPLICATION DE CE PROCEDE

(30) Priorität: 20.10.1999 DE 19951325
(43) Veröffentlichungstag der Anmeldung: 14.08.2002
(73) Patentinhaber: ATOTECH Deutschland GmbH, 10553 Berlin (DE)
(72) Erfinder: HÜBEL, Egon, 90537 Feucht (DE)
(74) Vertreter: Effert, Bressel und Kollegen
(86) Internationale Anmeldenummer: PCT/DE2000/003568
(87) Internationale Veröffentlichungsnummer: WO 2001/029289

(56) Entgegenhaltungen:
- EP-A- 0 395 542
- US-A- 4 272 351
- PATENT ABSTRACTS OF JAPAN vol. 1998, no. 14, 31. Dezember 1998 (1998-12-31) & JP 10 259500 A (DAIDO STEEL CO LTD), 29. September 1998 (1998-09-29)

## Beschreibung

Die Erfindung betrifft ein Verfahren und eine Vorrichtung zum elektrolytischen Behandeln von elektrisch gegeneinander isolierten, elektrisch leitfähigen Strukturen auf Oberflächen von elektrisch isolierendem Folienmaterial sowie Anwendungen des Verfahrens.

Zur Metallbeschichtung von Bändern werden u.a. galvanotechnische Prozesse eingesetzt. Seit etlichen Jahren werden zu diesem Zweck sogenannte Reel-toreel-Behandlungsanlagen verwendet, durch die das Material hindurch transportiert und während des Transportes mit Behandlungsflüssigkeit in Kontakt gebracht wird.

Ein Verfahren zum elektrolytischen Ätzen von Aluminiumfolie ist in US-A-3.779.877 beschrieben, bei dem die Folie zuerst über anodisch gepolte Kontaktschuhe und danach in die galvanotechnischen Behandlungsbäder geführt wird. In den Behandlungsbädem wird die Folie in der Nähe von kathodisch gepolten Elektroden vorbeigeführt und danach wieder aus dem Bad heraus. Dabei wird die Folie wiederum über anodisch gepolte Kontaktschuhe geleitet.

Ein anderes Verfahren zur Behandlung von Metallbändern, -drähten oder -profilen ist in EP 0 518 850 A1 beschrieben, bei dem das elektrisch leitfähige Behandlungsgut zum elektrolytischen Beizen aufeinander folgend durch zwei mit wäßrigen Elektrolyten gefüllte Behälter geführt wird, wobei einer kathodischen Behandlung in dem ersten Behälter eine anodische Behandlung in dem zweiten Behälter folgt. Dabei wird Strom von einer Elektrode im ersten Behälter über das Gut zu einer Elektrode im zweiten Behälter geleitet, so daß durch das Behandlungsgut ein Stromkreis zwischen den in den aufeinander folgenden Behältern befindlichen Elektroden unterschiedlicher Polarität geschlossen wird. In alternativen Ausführungsformen können auch entgegengesetzt gepolte Elektroden in einem Behandlungsbehälter vorgesehen sein und weitere Elektroden in zusätzlichen Behältern.

Ferner ist aus EP 0 093 681 B1 ein Verfahren zum kontinuierlichen Beschichten von Drähten, Rohren und anderem Halbzeug aus Aluminium mit Nickel bekannt. Bei diesem Verfahren wird das Halbzeug zuerst in einen ersten Badbehälter und danach in einen zweiten Badbehälter überführt. In dem ersten Badbehälter wird das Halbzeug an einer negativ gepolten Elektrode und im zweiten Badbehälter an einer positiv gepolten Elektrode vorbeigeführt. In den Badbehältern befindet sich ein Metallisierungsbad. Dadurch daß das Halbzeug elektrisch leitfähig ist und gleichzeitig mit beiden Metallisierungsbädern in Kontakt steht, ist der Stromkreis zwischen den Elektroden, die mit einer Stromquelle verbunden sind, geschlossen. Gegenüber der negativ gepolten Elektrode im ersten Badbehälter wird das Halbzeug anodisch gepolt. Gegenüber der positiv gepolten Elektrode im zweiten Badbehälter wird das Halbzeug dagegen kathodisch gepolt, so daß dort Metall abgeschieden werden kann.

Aus EP 0 395 542 A1 ist ein Verfahren zum kontinuierlichen Beschichten eines aus Graphit, Aluminium oder dessen Legierungen bestehenden Substrats mit einem Metall bekannt, indem das Substrat nacheinander durch zwei miteinander verbundene, ein Aktivierungsbad bzw. ein Metallisierungsbad enthaltende Behälter geführt wird, wobei im ersten Behälter eine Kathode und im zweiten Behälter eine Anode angeordnet ist. Als Substrate können mit diesem Verfahren Stangen, Rohre, Drähte, Bänder und andere Halbzeuge beschichtet werden.

Ein grundsätzlicher Nachteil der vorgenannten Verfahren besteht darin, daß lediglich ganzflächig leitfähige Oberflächen elektrolytisch behandelt werden können, jedoch nicht elektrisch gegeneinander isolierte Strukturen.

Als Lösung zu letzterem Problem ist in WO 97/37062 A1 ein Verfahren zum elektrochemischen Behandeln von elektrisch gegeneinander isolierten Bereichen auf Leiterplatten vorgeschlagen worden. Danach werden die mit der Behandlungslösung in Kontakt gebrachten Leiterplatten mit stationären, von einer Stromquelle gespeisten Bürstenelektroden nacheinander in Kontakt gebracht, so daß ein elektrisches Potential an den einzelnen elektrisch leitfähigen Strukturen anliegen kann. Zwischen die vorzugsweise aus Metalldrähten gebildeten Bürsten und zwischen den Bürsten angeordnete Anoden wird ein elektrisches Potential angelegt.

Diese Vorrichtung weist den Nachteil auf, daß die Bürsten innerhalb sehr kurzer Zeit vollständig mit Metall überzogen werden, da etwa 90 % des Metalls auf den Bürsten abgeschieden wird und nur 10 % auf die zu metallisierenden Bereiche. Daher müssen die Bürsten bereits nach kurzer Betriebszeit wieder vom Metall befreit werden. Hierzu müssen die Bürsten wieder aus der Vorrichtung ausgebaut und vom Metall befreit werden, oder es sind aufwendig konstruierte Einrichtungen vorzusehen, mit deren Hilfe das Metall auf den Bürsten durch elektrochemische Umpolung der zu regenerierenden Bürsten wieder entfernt wird. Außerdem können die Bürstenspitzen feine Strukturen auf den Leiterplatten leicht schädigen. Dabei verschleißt das Bürstenmaterial ebenfalls schnell, indem feinste Teilchen abgerieben werden, die in das Bad gelangen und dort zu Störungen bei der Metallisierung führen. Insbesondere zur Metallisierung von sehr kleinen Strukturen, beispielsweise solche mit einer Breite bzw. Länge von 0,1 mm, müssen Bürsten mit sehr dünnen Drähten eingesetzt werden. Diese verschleißen besonders schnell. Von den verschlissenen Bürsten stammende Partikel gelangen dann in das Bad und in die Löcher von Leiterfolien und verursachen erhebliche Störungen.

Bei anderen bekannten Verfahren zur Metallisierung von elektrisch isolierten Strukturen werden stromlose Metallisierungsprozesse genutzt. Allerdings sind diese Verfahren langsam, aufwendig in der Verfahrensführung und teuer, da größere Mengen an chemischen Stoffen verbraucht werden. Die verbrauchten Stoffe sind häufig umweltschädlich und verursachen bei der Beseitigung daher weitere erhebliche Kosten. Außerdem ist nicht gewährleistet, daß nur die elektrisch leitfähigen Strukturen metallisiert werden. Es wird oft beobachtet, daß sich in diesem Falle das Metall auch auf den dazwischen liegenden elektrisch isolierenden Oberflächenbereichen abscheidet und zu Ausschuß führt.

In EP 0 838 542 A1 ist ein Verfahren zum elektrolytischen Beizen von metallischen Bändern, insbesondere Edelstahlbändern, Bändern aus Titan, Aluminium oder Nickel beschrieben, wobei der elektrische Strom ohne elektrisch leitende Berührung zwischen Band und Elektroden durch das Bad geleitet wird. Die Elektroden sind dem Band gegenüber angeordnet und kathodisch bzw. anodisch gepolt. Bei Durchführung dieses Verfahrens hat sich allerdings herausgestellt, daß die Stromausbeute bei einer elektrolytischen Behandlung sehr gering ist.

Schließlich ist in Patent Abstracts of Japan, C-315, Nov. 20, 1985, Vol. 9, No. 293, JP 60-135600 A eine Vorrichtung zur elektrolytischen Behandlung eines Stahlbandes offenbart. Das Band wird hierzu zwischen entgegengesetzt gepolten Elektroden durch ein Elektrolysebad hindurchgeführt. Um einen elektrischen Stromfluß zwischen den einander gegenüberliegenden, entgegengesetzt gepolten Elektroden zu verhindern, sind in der Ebene, in der das Bad geführt wird, Abschirmbleche zwischen den Elektroden vorgesehen.

Der vorliegenden Erfindung liegt von daher das Problem zugrunde, die Nachteile der bekannten elektrolytischen Behandlungsverfahren zu vermeiden und insbesondere eine Vorrichtung und ein Verfahren zu finden, mit denen mit geringem Aufwand eine kontinuierliche elektrolytische Behandlung von kleinen elektrisch gegeneinander isolierten, elektrisch leitfähigen Strukturen auf Oberflächen von elektrisch isolierendem Folienmaterial möglich ist, wobei auch gewährleistet sein soll, daß der apparative Aufwand gering und das Verfahren mit ausreichender Effizienz durchführbar ist. Insbesondere sollen das Verfahren und die Vorrichtung für die Herstellung von Leiterfolien in der Leiterplattentechnik einsetzbar sein.

Gelöst wird dieses Problem durch das Verfahren nach Anspruch 1, die Anwendungen des Verfahrens nach den Ansprüchen 14 und 16 und die Vorrichtung nach Anspruch 17. Bevorzugte Ausführungsformen der Erfindung sind in den Unteransprüchen angegeben.

Das erfindungsgemäße Verfahren und die Vorrichtung dienen zum elektrolytischen Behandeln von elektrisch gegeneinander isolierten, elektrisch leitfähigen Strukturen auf Oberflächen von elektrisch isolierendem Folienmaterial, wobei die elektrisch leitenden Strukturen nicht direkt elektrisch kontaktiert werden. Dadurch ist es möglich, strukturierte Bereiche, die elektrisch gegeneinander isoliert sind, elektrolytisch zu behandeln. Es können sowohl außenliegende Bereiche auf dem Folienmaterial behandelt werden als auch Lochwandungen in dem Material.

Zur Durchführung des erfindungsgemäßen Verfahrens wird das Folienmaterial von einem Speicher, beispielsweise einer Rolle, entladen (beispielsweise abgewickelt), dann auf einer Transportbahn durch eine Behandlungsanlage transportiert und dabei mit Behandlungsflüssigkeit in Kontakt gebracht. Nach dem Durchlauf durch die Anlage wird das Folienmaterial schließlich wieder auf einen Speicher, beispielsweise eine Rolle, geladen (beispielsweise aufgewickelt). Eine Möglichkeit besteht darin, das Material in horizontaler Transportrichtung zu transportieren. Die in diesem Fall als Ebene ausgebildete Transportbahn kann dann sowohl senkrecht stehen als auch horizontal ausgerichtet sein. Eine derartige Anordnung wird in sogenannten Reel-to-reel-Anlagen verwirklicht. Hierzu wird das Material mit bekannten Mitteln transportiert, beispielsweise mit Rollen oder Walzen. Alternativ kann das Folienmaterial in der Anlage auch über Umlenkrollen geführt werden und dadurch ein- oder mehrfach die Richtung in der Anlage ändern. Dadurch wird ein möglichst langer Weg in der Anlage erreicht, so daß die Behandlungszeit bei vorgegebener Vorschubgeschwindigkeit des Materials verlängert wird.

Die erfindungsgemäße Vorrichtung weist folgende Merkmale auf:
a. je mindestens eine erste und zweite Einrichtung zum Speichern des Folienmaterials, beispielsweise eine Rolle, auf der das Material gespeichert ist und für die Behandlung abgewickelt wird, und eine Rolle, auf die das Material nach der Behandlung wieder aufgewickelt wird;
b. geeignete Transportorgane, beispielsweise Rollen, Walzen oder andere Halteelemente, wie Klammern für den Transport des Folienmaterials auf einer Transportbahn durch eine Behandlungsanlage von der mindestens einen ersten Speichereinrichtung zu der mindestens einen zweiten Speichereinrichtung;
c. mindestens eine Einrichtung zum In-Kontakt-Bringen des Folienmaterials mit einer Behandlungsflüssigkeit, beispielsweise einen Behandlungsbehälter, in den das Material eingefahren werden kann, oder geeignete Düsen, mit denen die Flüssigkeit an die Materialoberflächen gefördert wird;
d. mindestens eine Elektrodenanordnung, jeweils bestehend aus mindestens einer kathodisch gepolten Elektrode und mindestens einer anodisch gepolten Elektrode, wobei die mindestens eine kathodisch gepolte Elektrode und die mindestens eine anodisch gepolte Elektrode mit der Behandlungsflüssigkeit in Kontakt bringbar sind; die Elektroden können zur einseitigen Behandlung des Materials entweder nur an einer Seite der Transportbahn oder zur beidseitigen Behandlung auch an beiden Seiten angeordnet sein; die kathodisch gepolten Elektroden und die anodisch gepolten Elektroden einer Elektrodenanordnung sind auf eine Seite der Transportbahn ausgerichtet;
e. mindestens eine Isolierwand zwischen den Elektroden jeweils einer Elektrodenanordnung;
f. mindestens eine Strom/Spannungsquelle, die mit den Elektrodenanordnungen verbunden ist, zur Erzeugung eines Stromflusses durch die Elektroden der Elektrodenanordnungen, wobei als Strom/Spannungsquelle ein Galvanogleichrichter oder eine vergleichbare Strom/Spannungsquelle oder eine Strom/Spannungsquelle zur Erzeugung von unioder bipolaren Strompulsen verwendet werden kann;
g. wobei die mindestens eine kathodisch gepolte Elektrode und die mindestens eine anodisch gepolte Elektrode durch die mindestens eine lsolierwand derart gegeneinander abgeschirmt sind, daß im wesentlichen kein elektrischer Strom direkt zwischen den gegensinnig gepolten Elektroden fließen kann.

Zur Durchführung des erfindungsgemäßen Verfahrens wird das Folienmaterial während des Transportes durch die Behandlungsanlage mit der Behandlungsflüssigkeit in Kontakt gebracht und an mindestens einer Elektrodenanordnung, jeweils bestehend aus mindestens einer kathodisch gepolten Elektrode und mindestens einer anodisch gepolten Elektrode, vorbeigeführt. Die kathodisch und anodisch gepolten Elektroden werden ebenfalls mit der Behandlungsflüssigkeit in Kontakt gebracht und mit einer Strom/Spannungsquelle verbunden, so daß zum einen ein Strom zwischen der kathodisch gepolten Elektrode und einer elektrisch leitfähigen Struktur auf dem Material und zum anderen ein Strom zwischen der anodisch gepolten Elektrode und derselben elektrisch leitfähigen Struktur auf dem Material fließt, wenn diese Struktur beiden Elektroden gleichzeitig gegenüberliegt.

Wird eine zweiseitige Behandlung des Materials gewünscht, müssen Elektroden an beiden Seiten des Materials angeordnet sein. Bei einseitiger Behandlung reichen Elektroden an einer Seite des Materials aus. Die Elektroden einer Elektrodenanordnung, bestehend jeweils aus mindestens einer anodischen und mindestens einer kathodischen Elektrode, werden derart angeordnet, daß sie auf eine Seite des Materials ausgerichtet sind und daß zwischen den Elektroden mindestens eine Isolierwand angeordnet ist.

Die Elektroden werden beispielsweise mit einem Galvanogleichrichter elektrisch verbunden. Werden mehrere Elektrodenanordnungen eingesetzt, so können alle Elektrodenanordnungen mit demselben Galvanogleichrichter verbunden werden. Unter bestimmten Bedingungen kann es aber auch vorteilhaft sein, die einzelnen Elektrodenanordnungen mit jeweils einem Galvanogleichrichter zu verbinden. Die Galvanogleichrichter können als Strom- oder als Spannungsquelle betrieben werden.

Dadurch daß eine elektrisch leitfähige Verbindung durch eine zu behandelnde Leitschicht auf den Strukturen des Materials besteht, die der kathodisch gepolten Elektrode bzw. der anodisch gepolten Elektrode gleichzeitig gegenüberliegen, werden diese Strukturen gegenüber den Elektroden jeweils anodisch bzw. kathodisch gepolt. Dadurch werden an diesen Stellen elektrochemische Prozesse in Gang gesetzt. Zur Erzeugung eines Stromflusses in dem Material ist eine elektrische Kontaktierung des Materials nicht erforderlich. Das Material wirkt als Zwischenleiter. Eine Elektrode und die dieser Elektrode gegenüberliegende Struktur auf dem Material kann als elektrolytische Teilzelle betrachtet werden. Eine der beiden Elektroden dieser Teilzelle wird durch das Material selbst gebildet und die andere durch die Elektrode der Elektrodenanordnung. Dadurch daß das Material einer kathodisch und einer anodisch gepolten Elektrode gegenüber angeordnet wird, ergibt sich eine Serienschaltung von zwei derartigen elektrolytischen Teilzellen, die von einer Strom/Spannungsquelle, beispielsweise einem Galvanogleichrichter, gespeist werden.

Der Vorteil des erfindungsgemäßen Verfahrens und der Vorrichtung gegenüber bekannten Verfahren und Vorrichtungen besteht darin, daß der apparative Aufwand zur Erzeugung eines Stromflusses in dem zu behandelnden Material sehr viel geringer ist als bei vielen bekannten Verfahren und Vorrichtungen. Im vorliegenden Fall brauchen keine Kontaktierelemente vorgesehen zu werden. Das Material wird berührungslos gepolt. Dadurch ist die Abscheidung von Metall insbesondere mit einer geringen Schichtdicke sehr kostengünstig durchführbar. Ferner kann die Anordnung sehr einfach ausgeführt werden.

Das erfindungsgemäße Verfahren und die Vorrichtung ermöglichen daher die elektrolytische Behandlung von elektrisch gegeneinander isolierten, elektrisch leitfähigen Metallinseln (Strukturen) mit geringem Aufwand.

Gegenüber dem für die Leiterplatttentechnik vorgeschlagenen Verfahren zur Metallisierung von gegeneinander isolierten Metallinseln mit Bürstenanordnungen weisen das erfindungsgemäße Verfahren und die Vorrichtung den Vorteil auf, daß nur geringe Mengen an Metall auf der kathodisch gepolten Elektrode nutzlos abgeschieden werden. Der Rhythmus, mit dem das Metall von den kathodisch gepolten Elektroden wieder entfernt werden muß, liegt im Bereich von einigen Tagen bis Wochen. Außerdem stellt sich nicht das dortige Problem, daß die Bürstenelektroden bei der Berührung der zu metallisierenden Oberflächen verschleißen und dadurch Abriebpartikel das Behandlungsbad verunreinigen.

Da die gegensinnig zueinander gepolten Elektroden einer Elektrodenanordnung derart gegeneinander abgeschirmt werden, daß im wesentlichen kein elektrischer Strom direkt zwischen diesen Elektroden fließen kann, wird die Effizienz des Verfahrens gegenüber bekannten Verfahren und Vorrichtungen um ein Vielfaches gesteigert, da die Stromausbeute sehr viel größer ist. Erst indem erfindungsgemäß eine Isolierwand zwischen den entgegengesetzt gepolten Elektroden in den Elektrodenanordnungen vorgesehen ist, kann auch auf den elektrisch isolierten Strukturen eine Nettowirkung dadurch erzielt werden, daß der Abstand zwischen den Elektroden je nach der Größe der zu behandelnden Strukturen eingestellt wird, wobei ein ausreichender Wirkungsgrad des Verfahrens aufrechterhalten wird: Bei kleinen Strukturen ist ein kleiner Abstand erforderlich; bei größeren kann der Abstand auch größer sein. Durch die Isolierwand wird dabei ein direkter Stromfluß zwischen den entgegengesetzt gepolten Elektroden (Kurzschlußstrom) und ebenso ein direkter Stromfluß von der einen Elektrode zu dem Bereich auf dem zu behandelnden Substrat, das der anderen Elektrode gegenüber liegt, verhindert und umgekehrt.

Vorteilhaft ist auch die Option, daß sehr hohe Ströme problemlos auf das zu behandelnde Material übertragen werden können, ohne daß die elektrisch leitfähigen Oberflächenstrukturen auf dem Material erhitzt und beschädigt oder gar zerstört werden, da keine Kontaktmittel erforderlich sind. Durch die wirkungsvolle Kühlung des zu beschichtenden Materials durch die umgebende Behandlungsflüssigkeit kann die spezifische Strombelastung in der zu behandelnden Metallschicht sehr hoch eingestellt werden, beispielsweise auf bis zu 100 A/mm².

Das Verfahren und die Vorrichtung können zur Durchführung von beliebigen elektrolytischen Prozessen eingesetzt werden: Galvanisieren, Ätzen, Oxidieren, Reduzieren, Reinigen, elektrolytische Unterstützung an sich nicht elektrolytischer Prozesse, beispielsweise zum Starten eines stromlosen Metallisierungsprozesses. Beispielsweise können an den Oberflächen des Materials auch Gase erzeugt werden, nämlich Wasserstoff in einer kathodischen Reaktion und/oder Sauerstoff in einer anodischen Reaktion. Es ist auch möglich, daß diese Einzelprozesse zusammen mit anderen Verfahren, beispielsweise Metallisierungsprozessen oder anderen elektrochemischen Prozessen, gleichzeitig ablaufen.

Anwendungsgebiete des erfindungsgemäßen Verfahrens bzw. der Vorrichtung sind unter anderem:
- das Abscheiden dünner Metallschichten;
- das Übertragen von Oberflächenschichten aus Metall innerhalb einer Platte oder Folie von einem Opferbereich zu einem anderen Bereich, beispielsweise um Oberflächenschichten mit dem Metall zu verstärken, das von dem Opferbereich gewonnen wird;
- das Abdünnen durch Ätzen, beispielsweise der Abtrag einer Schicht von mehreren µm von den Oberflächen des Materials;
- das Pulsätzen;
- das Abscheiden von Metall mit Pulsstrom;
- das elektrolytische Oxidieren und Reduzieren von metallischen Oberflächen;
- das elektrolytische Reinigen durch anodische oder kathodische Reaktion (beispielsweise unter elektrolytischer Bildung von Wasserstoff oder Sauerstoff);
- das elektrolytische Entgraten von mit Strukturen versehenen gelochten Folien;
- das Ätzreinigen mit elektrolytischer Unterstützung; sowie weiterer Prozesse, bei denen eine elektrolytische Unterstützung vorteilhaft ist.

Besonders gut einsetzbar sind das Verfahren und die Vorrichtung zur Abscheidung dünner Metallschichten, beispielsweise von bis zu 5 µm dicken Schichten.

Zur Durchführung des erfindungsgemäßen Verfahrens können unter anderem die folgenden Randbedingungen eingestellt werden:
- die Art des Werkstoffes, aus dem die Grundleitschicht des zu behandelnden Materials gebildet ist;
- die Art des Beschichtungsmetalls;
- die Art und die Parameter des elektrolytischen Prozesses, beispielsweise die Stromdichte;
- die Zusammensetzung der Behandlungsflüssigkeit;
- die Geometrie der Behandlungsvorrichtung, beispielsweise die Breite der Elektrodenräume in Transportrichtung.

Durch eine optimale Wahl von Kombinationen der vorgenannten Parameter kann die elektrolytische Behandlung gesteuert werden. Beispielsweise kann durch Wahl eines bestimmten Metallabscheidungsbades bewirkt werden, daß das bereits abgeschiedene Metall nicht wieder abgeätzt wird, da der Metallauflösungsprozess in diesem Fall gehemmt ist. Gleichfalls kann durch geeignete Wahl eines Ätzbades erreicht werden, daß die Metallabscheidung in diesem Bad gehemmt wird.

Um das Verfahren zum Ätzen von Metalloberflächen auf dem Material durchzuführen, wird das Material zuerst an mindestens einer anodisch gepolten und danach an mindestens einer kathodisch gepolten Elektrode vorbeigeführt.

Das Verfahren und die Vorrichtung können zur Metallisierung eingesetzt werden. Hierzu wird das Material zuerst an mindestens einer kathodisch gepolten und danach an mindestens einer anodisch gepolten Elektrode vorbeigeführt. Zum elektrolytischen Metallisieren wird vorzugsweise Material mit Strukturen eingesetzt, die mit einer beim elektrolytischen Metallisieren unlöslichen Oberfläche versehen sind. Beispielsweise können mit dem erfindungsgemäßen Verfahren und der Vorrichtung Endschichten aus Metall auf Leiterfolien, beispielsweise eine Zinnschicht auf Kupfer, gebildet werden.

Eine weitere Anwendung des Verfahrens und der Vorrichtung besteht darin, Leiterfolienmaterial nach dem Bohren durch elektrolytisches Ätzen zu entgraten. Für die Entgratung von Leiterplatten werden bis heute Vorrichtungen eingesetzt, die auf mechanischen Verfahren beruhen, beispielsweise rotierende Bürsten, mit denen der Grat entfernt wird. Derartige mechanische Verfahren sind für Folienmaterialien überhaupt nicht einsetzbar, da die Folienmaterialien durch die mechanische Behandlung zerstört werden würden.

Das Prinzip des erfindungsgemäßen Verfahrens und der Vorrichtung wird nachfolgend an Hand von
- **Fig. 1:**: schematische Darstellung der erfindungsgemäßen Vorrichtung; und
- **Fig. 2:**: schematische Darstellung des Prinzips des erfindungsgemäßen Verfahrens
erläutert.

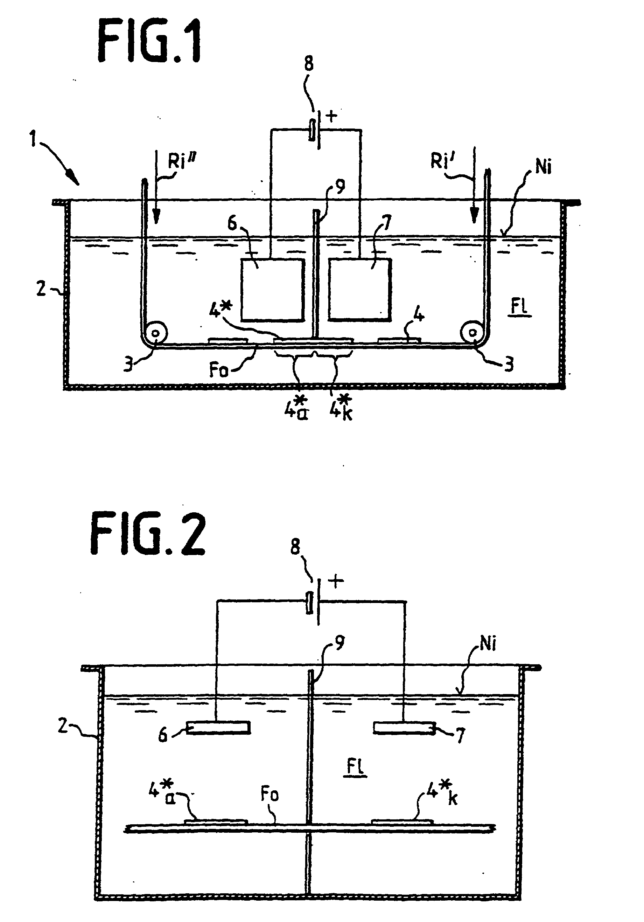

In **Fig. 1** ist ein Badbehälter **2** in einer Behandlungsanlage **1** gezeigt, der bis zum Niveau **Ni** mit einer geeigneten Behandlungsflüssigkeit **Fl** gefüllt ist. Elektrisch isolierendes Folienmaterial **Fo** mit elektrisch gegeneinander isolierten, elektrisch leitfähigen Strukturen **4** wird mit geeigneten Transportmitteln **3,** wie beispielsweise Rollen oder Walzen, in horizontaler Richtung **Ri'** oder **Ri"** durch die Behandlungsflüssigkeit **Fl** hindurchgeführt. Im Badbehälter **2** befinden sich ferner zwei Elektroden **6,7,** die mit einer Strom/Spannungsquelle **8** verbunden sind. Die Elektrode **6** ist kathodisch gepolt, die Elektrode **7** anodisch. Zwischen den beiden Elektroden **6,7** ist eine Isolierwand **9** (beispielsweise aus Kunststoff) angeordnet, die die beiden Elektroden quer zur Transportrichtung elektrisch gegeneinander abschirmt. Diese Wand **9** wird vorzugsweise so dicht an die Folie **Fo** herangeführt, daß sie sie während des Passierens berührt oder zumindest an sie heranreicht

Während die Folie **Fo** an den Elektroden **6,7** vorbeibewegt wird, werden die Strukturen **4*** polarisiert, und zwar in den Bereichen **4***_{**a**} anodisch, die der kathodisch gepolten Elektrode **6** gegenüberliegen, und in den Bereichen **4***_{**k**} kathodisch, die der anodischen Elektrode **7** gegenüberliegen.

Wird die Folie **Fo** beispielsweise in der Richtung **Ri'** an den Elektroden **6,7** vorbeigeführt, so werden die Strukturen **4** geätzt: In diesem Fall wird der linke Bereich **4***_{**a**} der Struktur **4*** in der in **Fig. 1** gezeigten Position anodisch gepolt, so daß Metall von der Leiterzugstruktur abgeätzt wird. Der rechte Bereich **4***_{**k**} dieser Struktur **4*** ist dagegen zur anodisch gepolten Elektrode **7** hin ausgerichtet und daher negativ gepolt. Wenn die Behandlungsflüssigkeit **Fl** keine weiteren elektrochemisch aktiven Redoxpaare enthält, wird in diesem Bereich **4***_{**k**} Wasserstoff entwickelt. In der Summe wird also Metall von den Strukturen **4** abgelöst. Dieser Vorgang läuft bei einer einzelnen Struktur 4 solange ab, wie sich diese Struktur gleichzeitig in den Wirkbereichen der beiden entgegengesetzt gepolten Elektroden **6** und **7** befindet.

Falls die Folie **Fo** metallisiert werden soll, muß sie in Richtung **Ri"** transportiert werden. In diesem Fall wird ein Metallisierungsbad als Behandlungsflüssigkeit **Fl** eingesetzt. Zuerst treten die jeweils rechten Kanten der Strukturen **4** in den Bereich der kathodisch gepolten Elektrode **6** und danach in den Bereich der anodisch gepolten Elektrode **7** ein. Der rechte Teil **4***_{**k**} der Struktur **4*** liegt in der in **Fig. 1** gezeigten Position der anodisch gepolten Elektrode **7** gegenüber und wird daher kathodisch gepolt. Dagegen liegt der linke Teil **4***_{**a**} der Struktur **4*** der kathodisch gepolten Elektrode **6** gegenüber, so daß dieser Teil anodisch gepolt wird. ist beispielsweise eine Leiterzugstruktur, die aus Kupfer als Grundleitschicht besteht, mit Zinn aus einem Zinnionen enthaltenden Verzinnungsbad **Fl** zu behandeln, so wird am linken Teil **4***_{**a**} der Struktur **4*** lediglich Sauerstoffentwickelt. Am rechten Teil **4***_{**k**} wird dagegen Zinn abgeschieden. In der Summe scheidet sich daher Zinn auf den Kupferstrukturen ab.

In **Fig. 2** ist grundsätzlich dieselbe Anordnung, wie in **Fig. 1** beschrieben, mit einem Badbehälter **2** mit Elektrolytflüssigkeit **Fl** gezeigt. Das Niveau der Flüssigkeit **Fl** ist mit **Ni** bezeichnet. Zusätzlich zu **Fig. 1** wird hier die Wirkung des elektrischen Feldes der Elektroden **6** und **7** auf die Folie **Fo** schematisch wiedergegeben. Zwischen den Elektroden **6** und **7** befindet sich eine Isolierwand **9.** Die Bereiche **4***_{**a**} und **4***_{**k**} der metallischen Strukturen sind elektrisch miteinander verbunden. Am Bereich **4***_{**a**}, der der kathodisch gepolten Elektrode **6** gegenüberliegt, entsteht ein positiveres Potential, so daß dieser Bereich anodisch gepolt ist. Am Bereich **4***_{**k**} entsteht durch die gegenüberliegende, anodisch gepolte Elektrode **7** ein negativeres Potential, so daß dieser Bereich kathodisch gepolt wird. In der gezeigten Anordnung wird die Struktur **4***_{**k**} metallisiert, wenn die Elektrolytflüssigkeit **Fl** ein Metallisierungsbad ist. Gleichzeitig findet an der anodisch gepolten Struktur **4***_{**a**} ein anodischer Prozess statt. Falls die Elektrolytflüssigkeit **Fl** ein Verzinnungsbad ist und die Strukturen **4** aus Kupfer bestehen, wird Kupfer nicht aufgelöst. Statt dessen wird am Bereich **4***_{**a**} Sauerstoff entwikkelt.

Als Elektroden können beim elektrolytischen Prozess sowohl lösliche als auch unlösliche Elektroden eingesetzt werden. Lösliche Elektroden werden üblicherweise in Metallisierungsverfahren eingesetzt, um das bei der Metallisierung verbrauchte Metall in der Metallisierungslösung durch Auflösung wieder nachzubilden. Daher werden Elektroden aus dem Metall verwendet, das abgeschieden werden soll. Unlösliche Elektroden sind in der Behandtungsflüssigkeit auch bei Stromfluß inert. Beispielsweise können Blei-, platinierte Titan-, mit Iridiumoxid beschichtete Titan- oder Edeimetallelektroden eingesetzt werden.

Werden das Verfahren und die Vorrichtung zum elektrolytischen Metallisieren eingesetzt, so wird ein Metallionen enthaltendes Metallisierungsbad eingesetzt. Bei Verwendung von löslichen, anodisch gepolten Elektroden werden die Metallionen durch Auflösung dieser Elektroden nachgeliefert. Werden dagegen unlösliche Elektroden eingesetzt, so müssen die Metallionen entweder durch separate Zugabe von geeigneten Chemikalien ergänzt werden, oder es wird beispielsweise die in WO 9518251 A1 beschriebene Vorrichtung eingesetzt, bei der Metallteile durch im Metallisierungsbad enthaltene zusätzliche lonen eines Redoxpaares aufgelöst werden. In den Kupferbädern ist in diesem Fall ein Fe²⁺/Fe³⁺- oder ein anderes Redoxpaar enthalten.

In einer weiteren Verfahrens- und Vorrichtungsvariante können die Elektroden einer Elektrodenanordnung derart angeordnet werden, daß sie nur auf eine Seite des Materials ausgerichtet sind. Um in diesem Falle einen direkten Stromfluß zwischen den beiden Elektroden zu vermeiden, ist es vorteilhaft, zwischen den Elektroden mindestens eine Isolierwand (etwa aus einer 50 µm dicken Polyimidfolie) anzuordnen, die sehr dicht an das Material herangeführt wird. Die Isolierwände sind vorzugsweise derart angeordnet, daß sie das Material beim Transport durch das Elektrolysebad berühren oder daß sie zumindest unmittelbar an die Oberflächen des Materials heranreichen. Dadurch wird eine besonders gute Abschirmung der anodischen Elektrode von der kathodischen Elektrode erreicht.

Da kleine zu metallisierende Strukturen zur elektrolytischen Behandlung sowohl mindestens einer kathodischen als auch mindestens einer anodischen Elektrode gegenüber liegen müssen, darf der Abstand zwischen den Elektroden bei einer festgelegten Größe der Strukturen einen bestimmten Wert nicht überschreiten. Dadurch wird auch eine Obergrenze für die Dicke der Isolierwand festgelegt. Als Faustregel kann angenommen werden, daß die Dicke der Isolierwand maximal etwa der Hälfte der Ausdehnung der zu metallisierenden Strukturen entsprechen soll, wobei vorzugsweise jeweils die Abmessungen in der Transportrichtung des Materials zu vergleichen sind. Bei etwa 100 µm breiten Strukturen sollte die Dicke der Isolierwand 50 µm nicht überschreiten. Bei schmaleren Strukturen sind entsprechend dünne Isolierwände einzusetzen.

Zwischen den einzelnen Elektrodenanordnungen können außerdem weitere Isolierwände vorgesehen sein, um einen direkten Stromfluß zwischen den Elektroden weiterer hintereinander angeordneter Elektrodenanordnungen zu vermeiden.

Wird das Material nicht in die Behandlungsflüssigkeit eingetaucht, sondern mittels geeigneter Düsen mit der Flüssigkeit in Kontakt gebracht, kann dann auf die Isolierwände ganz verzichtet werden, wenn die Flüssigkeitsbereiche, die mit den einzelnen Elektroden in Kontakt stehen, nicht miteinander in Kontakt kommen.

In einer alternativen Verfahrens- und Vorrichtungsvariante können die Elektroden einer Elektrodenanordnung auch derart angeordnet sein, daß sie auf unterschiedliche Seiten des Materials ausgerichtet sind. In diesem Fall wirkt das Material selbst als Isolierwand zwischen den Elektroden, so daß auf die Verwendung von Isotierwänden zwischen den Elektroden einer Elektrodenanordnung verzichtet werden kann, wenn die Elektroden nicht über das Material hinausragen. Diese Verfahrens- und Vorrichtungsvariante kann dann angewendet werden, wenn die elektrisch leitfähigen Bereiche auf den beiden Seiten des Materials elektrisch miteinander verbunden sind. Diese Anordnung ist beispielsweise für die Behandlung von durchkontaktierten, einseitig funktionellen Leiterfolien geeignet. Dadurch daß beispielsweise Material mit einer ganzflächigen elektrisch leitfähigen Schicht auf der der Funktionsseite gegenüberliegenden Seite verwendet wird, kann die kathodisch gepolte Elektrode dieser leitfähigen Schicht gegenüber angeordnet werden und die anodisch gepolte Elektrode der Funktionsseite, um Metall auf den Leiterstrukturen der Funktionsseite abzuscheiden. Gleichzeitig wird Metall von der gegenüberliegenden leitfähigen Schicht abgelöst.

Eine Elektrodenanordnung kann sich senkrecht oder schräg zu der Richtung, in der das Material in der Behandlungsanlage transportiert wird, vorzugsweise über die gesamte Behandlungsbreite der Ebene erstrecken, in der die Transportbahn für das Material verläuft. Die in Transportrichtung gesehene räumliche Ausdehnung der Elektrodenanordnungen wirkt sich in entscheidender Weise auf die Dauer der elektrolytischen Behandlung aus. Für große Strukturen auf dem Material können lange Elektrodenanordnungen eingesetzt werden. Bei der Behandlung von sehr feinen Strukturen müssen dagegen sehr kurze Elektrodenanordnungen eingesetzt werden.

Unter Bezugnahme auf **Fig. 1** kann dies näher erklärt werden: Wird das Material **Fo** von links nach rechts bewegt (Transportrichtung **Ri"**; Fall: Gaivanisierung), wird die vorlaufende rechte Kante einer Struktur **4*** länger galvanisiert als die nachlaufenden Bereiche der Struktur. Dadurch wird eine ungleichmäßige Schichtdicke erhalten. Die maximale Dicke der Schicht hängt im wesentlichen von der Länge der Elektrodenanordnung in Transportrichtung **Ri',Ri"**, ferner von der Transportgeschwindigkeit, der Stromdichte und den Abmessungen der Strukturen **4** in Transportrichtung **Ri',Ri"** ab. in Transportrichtung **Ri',Ri"** lange Elektrodenanordnungen und zugleich lange Strukturen **4** führen, absolut gemessen, zu großen Schichtdickenunterschieden bei großer Anfangsschichtdicke. Mit geringerer Länge der Elektrodenanordnungen in Transportrichtung **Ri',Ri"** werden die Schichtdickenunterschiede geringer. Gleichzeitig nimmt die Behandlungszeit ab. Die Dimensionierung der Elektrodenanordnungen ist daher dem Bedarf anzupassen. Bei feinsten Leiterzugstrukturen, beispielsweise 0,1 mm großen Pads oder 50 µm breiten Leiterzügen, soll die Länge der Elektrodenanordnungen im unteren Millimeter-Bereich liegen.

Um die Verfahrenswirkung zu vervielfachen, können mindestens zwei Elektrodenanordnungen in einer Behandlungsanlage vorgesehen werden, an denen das Material nacheinander vorbeigeführt wird. Die Elektroden dieser Elektrodenanordnungen können langgestreckt ausgebildet und im wesentlichen parallel zur Transportebene angeordnet sein. Die Elektroden können sowohl im wesentlichen senkrecht zur Transportrichtung ausgerichtet sein oder einen Winkel α ≠ 90° mit der Transportrichtung bilden. Sie erstrecken sich vorzugsweise über die gesamte Breite der vom Material eingenommenen Transportebene.

Mit einer Anordnung, bei der die Elektroden einen Winkel α ≠ 90° mit der Transportrichtung bilden, wird erreicht, daß sowohl parallel zur Transportrichtung als auch senkrecht dazu ausgerichtete elektrisch isolierte Metallstrukturen der gewünschten elektrolytischen Reaktion länger ausgesetzt werden, als wenn α ≈ 90° (± 25°). Wäre der Winkel α ≈ 90°, so würden in Transportrichtung ausgerichtete Leiterzüge bei gegebener Transportgeschwindigkeit und gegebener Elektrodenlänge ausreichend lange elektrolytisch behandelt, während senkrecht dazu ausgerichtete Leiterzüge nur kurzzeitig in der Elektrodenanordnung behandelt würden. Dies liegt daran, daß eine elektrolytische Behandlung nur solange möglich ist, wie die Struktur gleichzeitig der anodisch gepolten und der kathodisch gepolten Elektrode einer Elektrodenanordnung gegenüberliegt. Bei Strukturen, die parallel zur Elektrodenanordnung und damit zu den Elektroden ausgerichtet sind, ist diese Kontaktzeit kurz. Umgekehrtes gilt für den Fall, daß die Elektrodenanordnungen parallel zur Transportrichtung ausgerichtet sind (α ≈ 0° (± 25°)).

Die erfindungsgemäße Vorrichtung kann auch mehrere Elektrodenanordnungen mit langgestreckt ausgebildeten Elektroden aufweisen, wobei die Elektroden unterschiedlicher Elektrodenanordnungen unterschiedliche Winkel mit der Transportrichtung bilden. Insbesondere ist eine Anordnung von mindestens zwei langgestreckten Elektrodenanordnungen vorteilhaft, wobei der Winkel zwischen den Elektrodenanordnungen und der Transportrichtung des Materials in der Behandlungsanlage α ≠ 90° ist und die Elektrodenanordnungen etwa senkrecht zueinander angeordnet sind. Vorzugsweise ist α₁ ≈ 45° (erste Elektrodenanordnung), insbesondere 20° bis 70°, und α₂ ≈ 135° (zweite Elektrodenanordnung), insbesondere 110° bis 160°.

In einer besonders bevorzugten Verfahrensweise werden die Elektroden im wesentlichen parallel zur Transportebene oszillierend bewegt.

Ferner können auch mehrere parallel zueinander angeordnete, benachbarte Elektrodenanordnungen mit langgestreckt ausgebildeten Elektroden und jeweils dazwischen angeordneten Isolierwänden vorgesehen sein und benachbarte Elektroden jeweils von einer separaten Strom/Spannungsquelle gespeist werden. In diesem Falle wird dann, wenn beispielsweise eine Metallisierungslösung eingesetzt wird, zuerst Metall auf den isolierten Strukturen des Materials abgeschieden. Da sich die während des Transportes voranlaufenden Bereiche der Strukturen länger im Metallisierungsbereich befinden als die nachlaufenden Strukturen, ist die Metallschichtdicke auf ersteren größer. Passiert das Material dann die zweite Elektrodenanordnung, bestehend aus der zweiten Elektrode in der ersten Anordnung oder einer dritten Elektrode und einer weiteren gegensinnig gepolten Elektrode in der zweiten Anordnung, so wird viel Metall von den voranlaufenden Bereichen des Materials wieder abgelöst und auf den nachlaufenden Strukturen mehr Metall abgeschieden als abgelöst. Somit ergibt sich in der Summe bei der Behandlung in den zwei Elektrodenanordnungen eine Vergleichmäßigung der Metallschichtdicke auf den Strukturen.

Um mit dieser Anordnung eine besonders gleichmäßige Metallschichtdicke zu erreichen, kann die Stromdichte an den der ersten Elektrodenanordnung gegenüberliegenden Strukturen auf einen Wert eingestellt werden, der etwa doppelt so groß ist wie die Stromdichte an den der zweiten Elektrodenanordnung gegenüberliegenden Strukturen.

In einer weiteren bevorzugten Verfahrensweise können die Elektrodenanordnungen ferner von Isolierwänden umgeben werden. Falls mehrere benachbarte Elektrodenanordnungen eingesetzt werden, werden diese Isolierwände zwischen den Elektrodenanordnungen angeordnet. Durch diese die Elektrodenanordnungen umgebenden Isolierwände und die zwischen den Elektroden angeordneten Isolierwände werden zur Transportebene hin gerichtete Öffnungen gebildet.

Diese Öffnungen können je nach den gestellten Anforderungen unterschiedlich große Weiten aufweisen. Beispielsweise weisen diese Öffnungen in Transportrichtung gesehen jeweils eine derartige Weite auf, daß die den kathodisch gepolten Elektroden zugeordneten Öffnungen kleiner sind als die den anodisch gepolten Elektroden zugeordneten Öffnungen, wenn das Verfahren zum Abscheiden von Metall auf dem Material angewendet wird, oder daß die den kathodisch gepolten Elektroden zugeordneten Öffnungen größer sind als die den anodisch gepolten Elektroden zugeordneten Öffnungen, wenn das Verfahren zum Ätzen von Metalloberflächen auf dem Material angewendet wird.

Mit dieser Ausführungsform wird erreicht, daß die Stromdichte an den den kathodisch gepolten Elektroden gegenüberliegenden Bereichen auf den zu behandelnden Materialstücken verschieden ist von der Stromdichte an den den anodisch gepolten Elektroden gegenüberliegenden Bereichen. Durch diese Unterschiede können unterschiedlich große Potentiale an diesen Bereichen eingestellt werden, um bestimmte Elektrolyseprozesse zu begünstigen und andere zurückzudrängen. Damit ist es beispielsweise möglich, die Abscheidung von Metall gegenüber der konkurrierenden Auflösung des Metalls zu beschleunigen, um auf diese Weise auch Metalle in größerer Dicke auf dem Material abzuscheiden. Indem in dem genannten Falle die Stromdichte und damit das Potential an dem der kathodisch gepolten Elektrode gegenüberliegenden Bereich auf dem Material erhöht wird, läuft dort als konkurrierende Reaktion die Wasserzersetzung (Sauerstoffentwicklung) ab. Dadurch wird weniger Metall aufgelöst als an den zu den anodisch gepolten Elektroden korrespondierenden Materialoberflächen Metall abgeschieden wird. Umgekehrtes gilt natürlich für die Anwendung, bei der Metall geätzt wird.

Um Metallabscheidung auf den kathodisch gepolten Elektroden zu verhindern, können diese mit ionensensitiven Membranen abgeschirmt werden, so daß Elektrolyträume gebildet werden, die die kathodisch gepolten Elektroden umgeben. Falls keine ionensensitiven Membranen eingesetzt werden, muß auf den kathodisch gepolten Elektroden abgeschiedenes Metall im Tages- oder Wochenrhythmus wieder entfernt werden. Hierzu kann beispielsweise eine kathodisch gepolte Flächenelektrode zur Entmetallisierung dieser Elektroden angeordnet werden, wobei die metallisierten Elektroden in diesem Falle anodisch gepolt werden. Diese Entmetallisierungselektroden können in Produktionspausen anstelle des zu behandelnden Materials in die Elektrodenanordnung eingebracht werden. Sehr einfach ist auch ein zyklischer Tausch mit externer Entmetallisierung der kathodisch gepolten Elektroden.

Zur Behandlung des Materials kann es ferner vorteilhaft sein, die an die Elektroden der Elektrodenanordnungen angelegte elektrische Spannung derart zu modulieren, daß eine unipolare oder bipolare Strompulsfolge an den Elektroden fließt.

Die nachfolgenden Figuren dienen zur weiteren Erläuterung der Erfindung. Es zeigen im einzelnen:

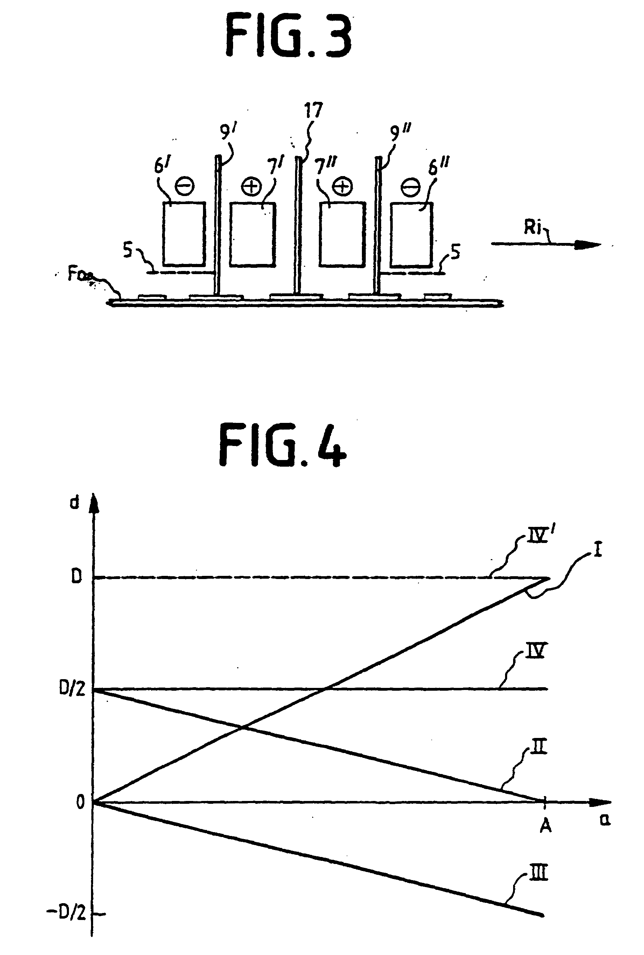

- **Fig. 3:**: eine schematische Darstellung des Aufbaus einer Elektrodenanordnung;
- **Fig. 4:**: den Schichtdickenverlauf einer Struktur nach Behandlung in der Vorrichtung nach **Fig. 3;**

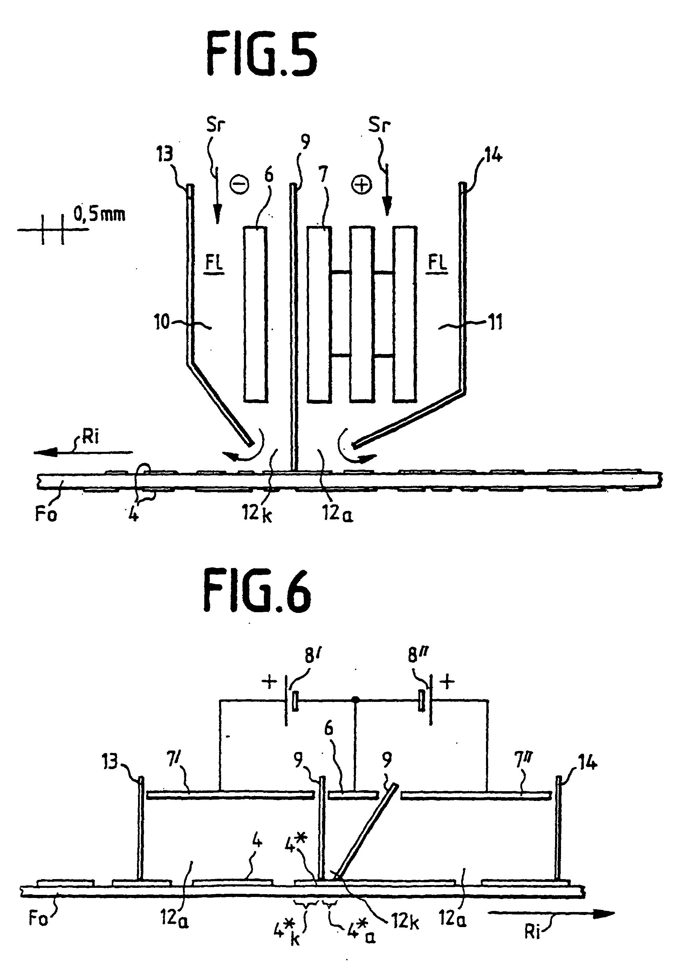

- **Fig. 5:**: eine schematische Darstellung von zwei Elektroden einer Elektrodenanordnung;
- **Fig. 6:**: eine schematische Darstellung von mehreren Elektroden, die unterschiedlichen Elektrodenanordnungen angehören;

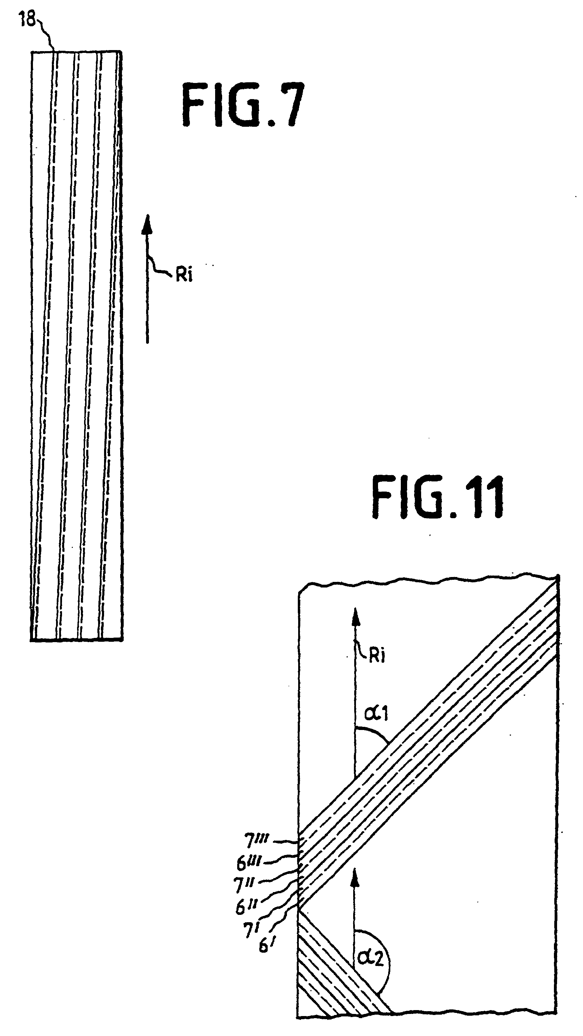

- **Fig. 7:**: eine spezielle Anordnung von mehreren Elektrodenanordnungen entlang des Transportweges für das Material in einer Durchlaufanlage;

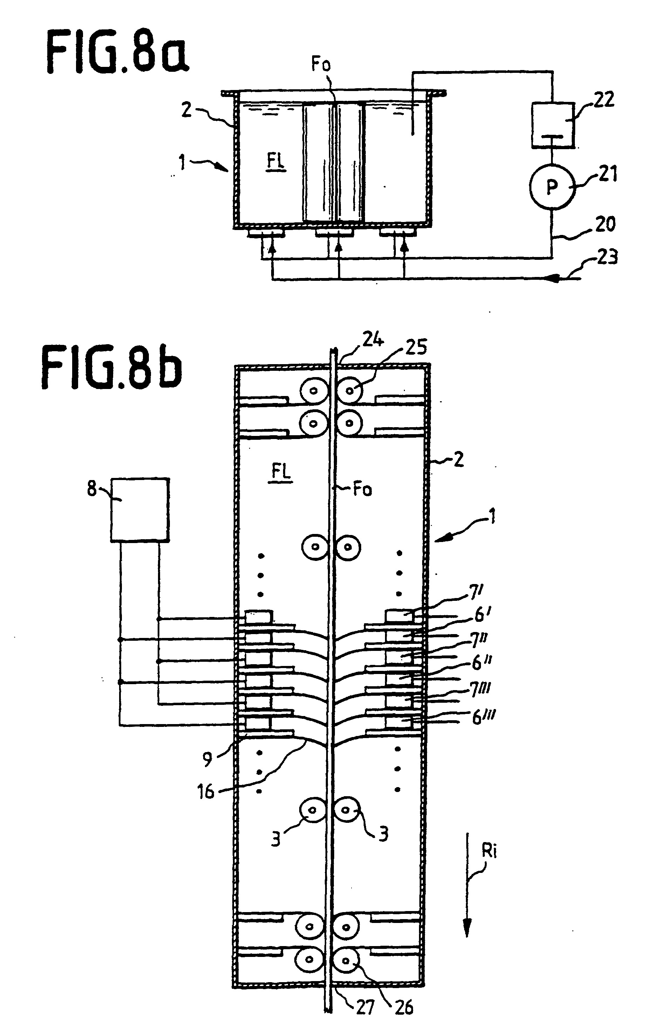

- **Fig. 8a:**: einen Schnitt durch eine Durchlaufanlage;
- **Fig. 8b:**: eine Draufsicht auf eine Durchlaufanlage;

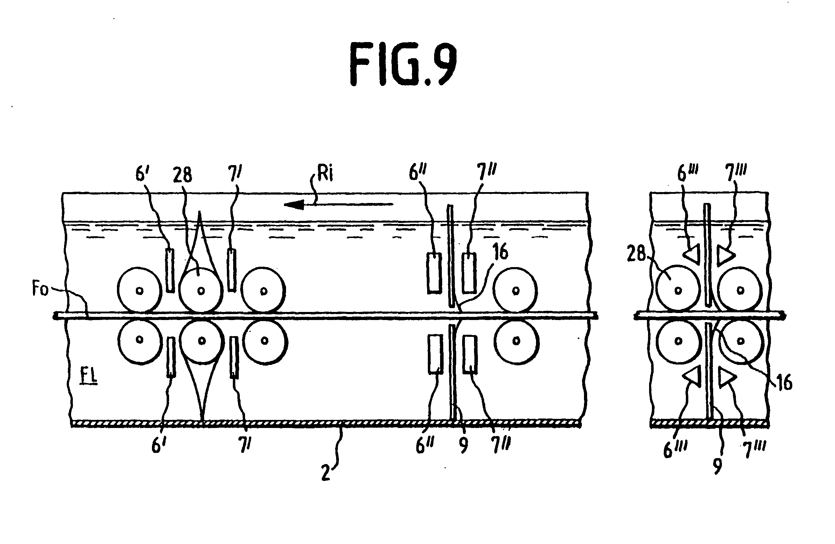

- **Fig. 9:**: einen seitlichen Schnitt durch eine Durchlaufanlage, bei der das Material in einer horizontalen Transportebene transportiert wird;

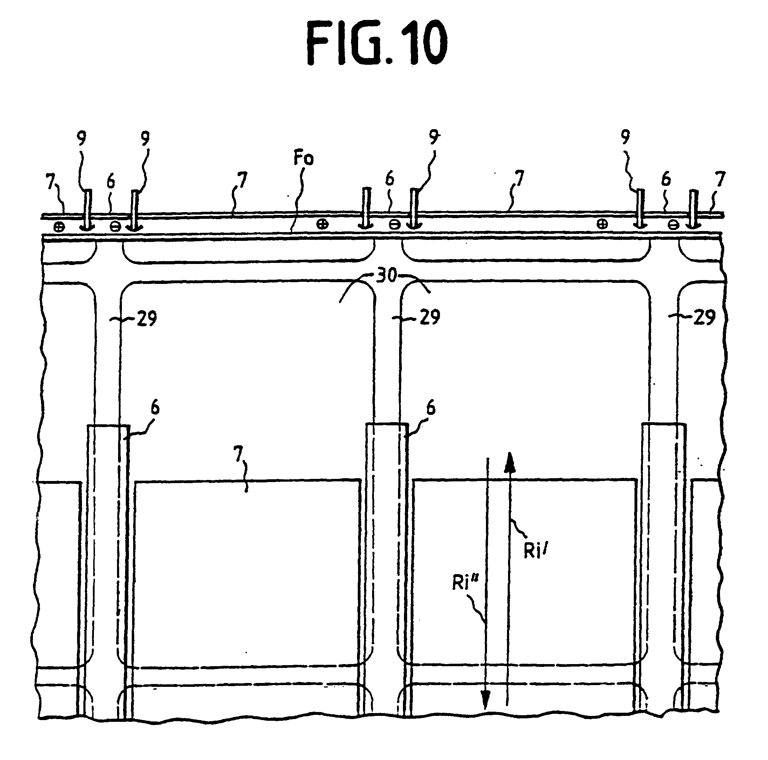

- **Fig. 10:**: eine Draufsicht auf eine Folie mit Kupferstrukturen und Projektion der Elektroden von mehreren Elektrodenanordnungen;

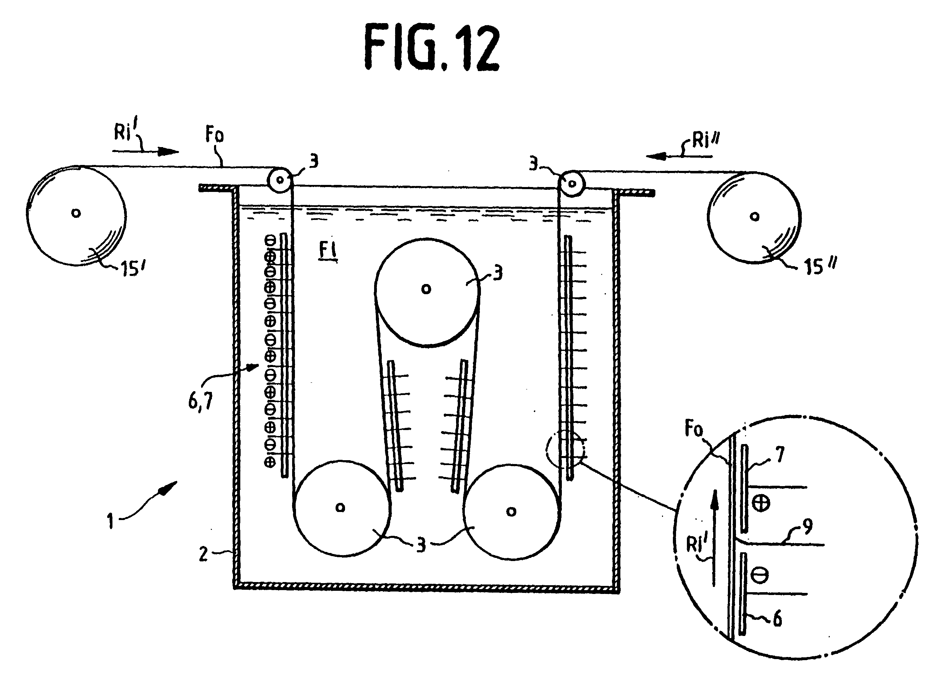

- **Fig. 11:**: eine weitere spezielle Anordnung von mehreren Elektrodenanordnungen entlang des Transportweges für das Material in einer Durchlaufanlage;
- **Fig. 12:**: eine schematische Darstellung einer Reel-to-reel-Anlage zur elektrolytischen Behandlung von Folienmaterial.

Eine Elektrodenanordnung gemäß den **Fig. 1** und **2** eignet sich hervorragend zur Behandlung von großen Metallstrukturen. Die Länge der Elektroden in Transportrichtung bestimmt zusammen mit der Transportgeschwindigkeit die Dauer der elektrolytischen Behandlung mit einer Elektrodenanordnung. Bei großen zu behandelnden Strukturen wird eine große Elektrodenlänge in Transportrichtung gewählt, zumindest soweit dies die prozeßbestimmende Elektrode betrifft.

Wird durch geeignete Prozeßparameter dafür gesorgt, daß durch die Behandlung an der zweiten Elektrode einer Elektrodenanordnung der an der ersten Elektrode zunächst erzielte Behandlungseffekt nicht oder zumindest nicht in wesentlichem Umfange wieder rückgängig gemacht wird, so können mehrere erfindungsgemäße Elektrodenanordnungen in Transportrichtung hintereinander angeordnet werden, d.h. eine Folie wird nacheinander an mehreren Elektrodenanordnungen vorbeigeführt. Die jeweiligen Behandlungsergebnisse, die mit den einzelnen Elektrodenanordnungen erreicht werden, summieren sich. Die Länge der Elektrodenanordnungen in Transportrichtung muß an die Größe der zu behandelnden Strukturen angepaßt werden. Bei der Behandlung kleiner Strukturen muß diese Länge auch klein gewählt werden. Die Anzahl der Elektrodenanordnungen muß bei einem geforderten Behandlungsergebnis entsprechend größer gewählt werden. Voraussetzung ist stets, daß das Behandlungsergebnis durch die jeweils nachfolgende Elektrode einer Elektrodenanordnung nicht wieder rückgängig gemacht wird. Beispielsweise soll eine bereits aufgebrachte Metallschicht beim Passieren einer nachfolgenden kathodisch gepolten Elektrode nicht wieder entfernt werden.

Bei sehr kleinen zu behandelnden Strukturen tritt die Behandlung der Randbereiche von zu behandelnden Strukturen, die zuerst bzw. zuletzt an den Elektroden vorbeigeführt werden, in den Vordergrund. Allerdings sollen auch diese Randbereiche möglichst gleichmäßig elektrolytisch behandelt werden. Hierzu wird die Möglichkeit, in der Elektrodenanordnung elektrochemisch "gegenläufige" Reaktionen (beispielsweise metallisieren, entmetallisieren) gezielt einstellen zu können, vorteilhaft eingesetzt. Anhand von **Fig. 3** wird das sehr gleichmäßige elektrolytische Behandeln auch kleinster Strukturen (Breite 0,1 mm) beschrieben.

In **Fig. 3** ist eine Anordnung mit zwei Elektrodenanordnungen wiedergegeben, die jeweils anodisch und kathodisch gepolte Elektroden **6',7',6",7"** aufweisen. Eine Folie **Fo** mit den Strukturen **4,** beispielsweise Leiterzugstrukturen aus Kupfer, wird in Transportrichtung **Ri** durch eine hier nicht dargestellte Elektrolytflüssigkeit hindurchgeführt. Als Elektrolytflüssigkeit wird in diesem Beispiel ein Verzinnungsbad eingesetzt.

Die kathodisch gepolten Elektroden **6',6"** sind durch ionensensitive Diaphragmen **5** von dem umgebenden Elektrolytraum abgeschirmt. Dadurch wird die Abscheidung von Zinn auf den Elektroden **6',6"** aus der Elektrolytflüssigkeit verhindert. Zwischen den Elektroden **6'** und **7'** bzw. **6"** und **7"** befinden sich jeweils Isolierwände **9'** bzw. **9"**. Zwischen den beiden Elektrodenanordnungen ist eine Isolierwand **17** angeordnet. Die Diaphragmen **5** können auch entfallen. In diesem Falle sind die kathodisch gepolten Elektroden **6',6"** von Zeit zu Zeit zu entmetallisieren.

In der ersten Elektrodenanordnung, in der sich die Elektroden **6'** und **7'** befinden, werden die Strukturen **4** metallisiert. Dadurch daß die Strukturen **4** von links nach rechts an der Elektrodenanordnung vorbeigeführt werden, wird der rechte Rand der Strukturen **4** der elektrolytischen Reaktion länger ausgesetzt als der linke Rand, so daß die abgeschiedene Metallmenge und damit die Metallschichtdicke größer ist als am linken Rand. Um dieses Ungleichgewicht zumindest teilweise auszugleichen, wird die Folie **Fo** nach dem Durchlaufen der ersten Elektrodenanordnung an der zweiten Elektrodenanordnung vorbeigeführt. In dieser Anordnung ist die Reihenfolge der kathodisch gepolten Elektrode **6"** und der anodisch gepolten Elektrode **7"** gegenüber der Polarität der Elektroden **6'** und **7'** in der ersten Elektrodenanordnung vertauscht, so daß jeweils der linke Rand der Strukturen **4** der elektrochemischen (Galvanisier)-Wirkung der Elektrode **7"** länger ausgesetzt ist als der jeweilige rechte Rand. Der rechte Rand der Strukturen **4** wird beim Passieren der kathodisch gepolten Elektrode **6"** anodisch gepolt und damit der anodischen Reaktion länger ausgesetzt als der linke Rand der Strukturen **4,** so daß in diesem Falle Metall bevorzugt am rechten Rand wieder abgelöst wird. Im Ergebnis wird eine weitgehend gleichmäßig dicke Zinnschicht abgeschieden.

Dieses Ergebnis läßt sich mit Hilfe des Diagramms in **Fig. 4** nachvollziehen, in dem die erhaltene Metallschichtdicke d als Funktion der Längenausdehnung a der zu beschichtenden Stuktur **4** wiedergegeben ist. Dieses Diagramm wurde unter der Randbedingung erstellt, daß der Strom in der zweiten Elektrodenanordnung halb so groß ist wie in der ersten Elektrodenanordnung und daß die Stromausbeute der elektrochemischen Reaktionen (Metallauflösung, Metall-; abscheidung) nahe 100% ist.

Die nach Durchlauf der Strukturen durch die erste Elektrodenanordnung meßbare Schichtdickenverteilung ist mit der Kurve **I** bezeichnet. Am linken Rand der Strukturen (a = 0) ist praktisch kein Metall abgeschieden worden, während am rechten Rand (a = A) die Schichtdicke D erreicht ist. Beim Passieren der zweiten Elektrodenanordnung finden zwei Prozesse statt: Am linken Rand wird praktisch nur Metall abgeschieden (Teilprozess, dargestellt durch Kurve **II**). Daher wird in diesem Bereich die Schichtdicke D/2 erreicht. Weiterhin wird am rechten Rand praktisch nur Metall abgelöst (Teilprozess, dargestellt durch Kurve **III**). Daher verringert sich die Schichtdicke an dieser Stelle von ursprünglich d = D auf d = D/2. Die dazwischen liegenden Bereiche auf der Struktur weisen ebenfalls im wesentlichen eine Schichtdicke von d = D/2 auf. Die resultierende Schichtdickenverteilung ist in Kurve **IV** angegeben.

Durch Optimierung des Behandlungsbades kann die Metallisierung noch verbessert werden: Indem ein Bad zur Metallabscheidung verwendet wird, das eine Metallauflösung nicht zuläßt, kann insgesamt eine größere Metallschichtdicke erreicht werden. In diesem Falle müssen die Ströme der ersten und der zweiten Elektrodenanordnung gleich groß sein. Die in **Fig. 4** gezeigte Kurve **III** fällt in diesem Falle mit der Abszisse zusammen, da kein Metall aufgelöst wird. Daher wird eine Dicke D der Schicht erhalten, die über die gesamte Oberfläche der Metallstrukturen konstant ist (Kurve **IV'**)

Eine weitere Vereinfachung der Anordnung gemäß **Fig. 3** wird dadurch erreicht, daß die mittleren Bereiche mit den Elektroden **7',7"** (in **Fig. 3**) zusammengefaßt werden zu einem Bereich mit einer Elektrode. Auch in diesem Falle werden zwei Strom/Spannungsquellen zur Stromversorgung der Elektroden benötigt, mit denen die unterschiedlichen Ströme an die beiden Teil-Elektrodenanordnungen, bestehend aus der Elektrode **6'** und der Elektrode **7',7"** einerseits und aus der Elektrode **7',7"** und der Elektrode **6"** andererseits, erzeugt werden können. Die Trennwand **17** entfällt in diesem Falle. Der mechanische Aufbau der Elektrodenanordnungen ist in diesem Falle besonders einfach.

In **Fig. 5** ist der schematische Aufbau einer Elektrodenanordnung in einer bevorzugten Ausführungsform der Erfindung wiedergegeben. Die Folie **Fo** mit den Strukturen **4** ist unterhalb der Elektrodenanordnung dargestellt (die an der Unterseite der Folie **Fo** liegenden Strukturen **4** werden von einer zweiten Elektrodenanordnung an der Unterseite der Folie elektrolytisch behandelt). Die Folie **Fo** wird in der Transportrichtung **Ri** geführt. Die Elektrodenanordnung besteht aus den Elektroden **6** (kathodisch) und **7** (anodisch). Zwischen den Elektroden **6** und **7** befindet sich eine Isolierwand **9,** die in diesem Falle auf der Folie **Fo** aufliegt und eine wirkungsvolle elektrische Abschirmung der Feldlinien, die von den Elektroden **6** und **7** ausgehen, bewirkt. Die Elektroden **6** und **7** sind vom Kathodenraum **10** und Anodenraum **11** umgeben, in dem sich die Elektrolytflüssigkeit **Fl** befindet. Die beiden Räume **10** und **11** öffnen sich zur Transportebene, in der die Folie **Fo** geführt wird. Durch zwei kleine Öffnungen **12**_{**k**} und **12**_{**a**}, die durch die seitlichen Isolierwände **13, 14** und die Isolierwand **9** zwischen den Elektroden **6** und **7** gebildet werden, wird eine Fokussierung der Wirkung der Elektroden auf einen kleinen Bereich der Folie **Fo** erreicht. Dies ist vorteilhaft, da dadurch die elektrolytische Behandlung der kleinen Strukturen **4** vergleichmäßigt wird. Im Gegensatz dazu ist die elektrolytische Behandlung von kleinen Strukturen bei Wahl großer Öffnungen **12**_{**a**}**,12**_{**k**} ungleichmäßig.

Wie in **Fig. 5** ebenfalls erkennbar, wird die Elektrolytflüssigkeit **Fl** von oben in die Elektrodenanordnungen gefördert (dargestellt durch die Pfeile **Sr**). Durch die hohe Fließgeschwindigkeit kann die elektrochemische Reaktion beschleunigt werden.

In **Fig. 6** ist eine weitere erfindungsgemäße Anordnung mit mehreren benachbarten Elektroden **6,7',7"** gezeigt. Die Elektroden **6,7',7"** sind mit den Strom/Spannungsquellen **8',8",** beispielsweise Galvanogleichrichtern, verbunden. Zwischen den Elektroden befinden sich Isolierwände **9.** Eine zu behandelnde Folie **Fo** wird in der Transportebene in Transportrichtung **Ri** bewegt. Die jeweiligen Elektrolyträume, die die Elektroden **6,7** umgeben, weisen zur Transportebene ausgerichtete Öffnungen **12**_{**a**}**,12**_{**k**} auf, die von den Isolierwänden **9** gebildet werden. Diese Öffnungen **12**_{**a**}**,12**_{**k**} sind unterschiedlich groß. Dadurch steilen sich unterschiedlich große Stromdichten und damit auch unterschiedliche Potentiale an den den Öffnungen **12**_{**a**}**,12**_{**k**} gegenüberliegenden Bereichen **4,4*** auf der Folie **Fo** ein.

Für den Fall, daß eine mit metallischen Bereichen **4** versehene Folie **Fo** in einer Metallabscheidelösung behandelt wird, ergibt sich folgende Situation:

Dadurch daß die Öffnung **12**_{**k**} an der kathodisch gepolten Elektrode **6** kleiner ist als die Öffnung **12**_{**a**} an der anodisch gepolten Elektrode **7,** wird eine höhere Stromdichte und damit ein höheres Potential an den der kathodisch gepolten Elektrode **6** gegenüberliegenden Bereichen **4***_{**a**} eingestellt als an den den anodisch gepolten Elektroden **7',7"** gegenüberliegenden Bereichen **4***_{**k**} des behandelten Bereichs **4*.** Dadurch wird beim anodischen Teilprozess im Bereich der kathodisch gepolten Elektrode **6** zusätzlich zur Metallauflösung auch die konkurrierende Sauerstoffentwicklung stattfinden, so daß weniger Metall in diesem Bereich **4***_{**a**} abgelöst als im Bereich **4***_{**k**} Metall abgeschieden wird. In der Summe wird daher eine Metallschicht gebildet.

In **Fig. 7** ist eine spezielle Anordnung von mehreren Elektrodenanordnungen **18** entlang der Transportbahn für das Material in einer Durchlaufanlage in Draufsicht wiedergegeben. Dabei sind die Elektroden **6',6",7',7"** in der Anordnung von **Fig. 1** durch die durchgezogenen und die strichlierten Geraden schematisch dargestellt. Die Elektrodenanordnungen **18** sind in Transportrichtung **Ri** leicht schräg gestellt und erstrecken sich in entsprechender Länge in der elektrolytischen Anlage. Jede Elektrodenanordnung **18** dient nur zur Behandlung eines Teils der Oberfläche des zu behandelnden Materials. Damit wird die Behandlungszeit erheblich verlängert. Weist die elektrolytische Anlage beispielsweise eine Länge von 1,40 m und eine Breite von 0,20 m auf, so ergibt dies bei der dargestellten Anordnung mit vier Elektrodenanordnungen **18** eine Verlängerung der Behandlungszeit von 1400 mm x 4 / 200 mm = 28. Bei einer aktiven Länge einer Elektrodenanordnung **18** von 1 mm ergibt sich somit bei einer Transportgeschwindigkeit von beispielsweise 0,1 m/min eine Behandlungszeit von etwa 17 sec. Bei einer mittleren Abscheidungsstromdichte in Höhe von 10 A/dm² beträgt die Schichtdicke von abgeschiedenem Kupfer etwa 0,6 µm. Werden mehrere Elektroden zur Behandlung von Teilbereichen des Materials eingesetzt, so multipliziert sich die Schichtdicke mit der Anzahl der Elektrodenanordnungen.

In **Fig. 8a** ist eine Durchlaufanlage **1** im Schnitt dargestellt. Ein Folienband **Fo** wird in diesem Fall beispielsweise mit Walzen transportiert und senkrecht gehalten. Das Band **Fo** wird in einen Behälter **2** von der Seite eingeführt, der das Behandlungsbad, beispielsweise eine Metallisierungslösung **Fl** enthält. Diese Lösung wird über geeignete Rohrleitungen **20** kontinuierlich aus dem Behälter **2** mittels einer Pumpe **21** abgezogen und über einen Filter **22** geführt, bevor sie wieder in den Behälter zurückgefördert wird. Außerdem kann zur Verwirbelung der Lösung **Fl** im Behälter **2** Luft über eine Rohrleitung **23** eingeleitet werden.

In **Fig. 8b** ist die in **Fig. 8a** gezeigte Anlage **1** in Draufsicht wiedergegeben, wobei die Einbauten nur teilweise dargestellt sind. Das Folienband **Fo** wird in Transportrichtung **Ri** geführt. Innerhalb des Behälters **2** befindet sich die Behandlungsflüssigkeit **Fl,** in diesem Falle eine zum elektrolytischen Ätzen geeignete Lösung. Das Band **Fo** wird über die Öffnung **24** und durch Abquetschwalzen **25** in den Behälter **2** eingeführt und zwischen Abquetschwalzen **26** und die Öffnung **27** hindurch aus dem Behälter wieder hinaus. Innerhalb des Behälters **2** wird das Band **Fo** mittels geeigneter Führungselemente **3** geführt, beispielsweise mit Rollen oder Walzen.

Im Behälter **2** befinden sich mehrere hintereinander und beidseits der Transportebene für das Band **Fo** angeordnete Elektrodenanordnungen, die jeweils aus kathodisch gepolten Elektroden **6',6",6''',...** und anodisch gepolten Elektroden **7',7",7''',...** gebildet sind. Zwischen den Elektroden befinden sich Isolierwände **9.** Diese Isolierwände **9** weisen elastische Dichtfolien **16** auf, die eine vollständige Abschirmung der elektrischen Felder der einzelnen Elektrodenräume gegeneinander dadurch ermöglichen, daß sie beim Passieren des Bandes **Fo** die Materialoberflächen berühren. Die Elektroden **6',6",6''',...,7',7",7''',...** sind mit einem Galvanogleichrichter **8** verbunden, wobei die Verbindungen der in **Fig. 8b** rechts gezeigten Elektroden mit dem Gleichrichter nicht dargestellt sind. Jede Elektrodenanordnung kann auch von getrennten Gleichrichtern gespeist werden.

Indem das Band **Fo** beispielsweise zuerst an einer anodisch gepolten Elektrode vorbeigeführt wird und dann an einer kathodisch gepolten Elektrode, wird Metall elektrolytisch abgetragen.

In **Fig. 9** ist eine Horizontalanlage für die elektrolytische Behandlung von Folienband **Fo** in seitlichem Schnitt dargestellt. Der Behälter **2** enthält die Behandlungsflüssigkeit **FI.** Die zu behandelnde Folie **Fo** wird horizontal in der Behandlungsflüssigkeit **FI** an den Elektrodenanordnungen vorbei in Transportrichtung **Ri** geführt. Die Elektrodenanordnungen bestehen wiederum aus jeweils kathodisch gepolten Elektroden **6',6",6''',...** und anodisch gepolten Elektroden **7',7",7''',....** Die Elektrodenanordnungen sind beidseits der Transportebene, in der die Folie **Fo** geführt wird, angeordnet.

Zur Isolierung der Elektroden **6',6",6''',...,7',7",7''',...** gegeneinander werden im vorliegenden Fall Isolierwalzen **28** mit Dichtlippen verwendet. Anstelle der Isolierwalzen **28** können auch Isolierwände **9** mit Dichtfolien **16** eingesetzt werden.

Im rechten Teil von **Fig. 9** ist eine alternative Ausführungsform und Anordnung der Elektroden **6''',7'''** relativ zu den Isolierwänden **9** und Dichtfolien **16** dargestellt.

In **Fig. 10** ist eine Draufsicht auf eine Folie **Fo** gezeigt, die Metall-Opferbereiche **29** und mit Metallstrukturen versehene Bereiche **30** aufweist (Strukturen nicht gezeigt), die elektrisch miteinander verbunden sind. Diese Folie **Fo** kann beispielsweise in einer Horizontalanlage behandelt werden, indem es in die Behandlungsflüssigkeit eingetaucht und an den erfindungsgemäßen Elektrodenanordnungen vorbeigeführt wird. Die Elektroden **6,7** der Elektrodenanordnungen sind hier in der Projektion auf die Folie **Fo** dargestellt. Die anodisch gepolten Elektroden **7** sind auf die strukturierten Bereiche **30** ausgerichtet und mit "⊕" bezeichnet und die kathodisch gepolten Elektroden **6** auf die aus Metall bestehenden Opferbereiche **29,** wobei diese mit "⊖" bezeichnet sind. Zwischen den Elektroden **6** und **7** sind Isolierwände **9** angeordnet. Die Isolierwände **9** und die Elektroden **6,7** sind in der Darstellung der **Fig. 10** nur angedeutet, wobei es sich bei diesem Detail um eine Schnittdarstellung durch die Zeichenebene der Figur handelt.

Das Materialstück wird in einer der Transportrichtungen **Ri'** und **Ri"** geführt. Dabei werden die Opferbereiche **29** aus Metall fortwährend an den kathodisch gepolten Elektroden **6** vorbeigeführt und lösen sich daher auf. Die strukturierten Bereiche **30** werden dagegen metallisiert, da sie an den Elektroden **7** vorbeigeführt werden. Mit dieser Anordnung ist die Abscheidung eines Metalls möglich, das mit dem Metall identisch ist, aus dem die strukturierten Bereiche bestehen.

In **Fig. 11** ist eine weitere bevorzugte erfindungsgemäße Vorrichtung schematisch dargestellt. Das Material wird in Transportrichtung **Ri** an den Elektrodenanordnungen vorbeigeführt, die jeweils aus langgestreckten Elektroden **6',6",6''',...** und **7,'7",7''',...** bestehen. Die Elektrodenanordnungen mit den Elektroden bilden einen Winkel α₁ bzw. einen Winkel α₂ gegenüber der Transportrichtung **Ri**. Dadurch wird der Einfluß der Behandlungzeit von gegenüber der Transportrichtung **Ri** unterschiedlich ausgerichteten Strukturen ausgeglichen. Da bei Leiterfolien die Leiterzüge üblicherweise parallel oder senkrecht zu einer Seitenkante der Folien verlaufen und damit parallel oder senkrecht zur Transportrichtung **Ri**, wird durch die dargestellte Ausrichtung der Elektrodenanordnungen eine gleich lange Behandlungszeit für Leiterzüge beider Ausrichtungen erreicht, soweit diese dieselbe Länge aufweisen.

In **Fig. 12** ist eine weitere Behandlungsanlage **1** schematisch dargestellt, mit der lange Folienbänder **Fo** elektrolytisch behandelt werden können. Derartige Anlagen **1** werden als Reel-to-reel-Anlagen bezeichnet.

Das Band **Fo** wird von einer ersten Rolle **15'**, die als Speicher für das Folienband **Fo** dient, abgewickelt, und auf eine zweite Rolle **15"** aufgewickelt, wenn das Band in der Transportrichtung **Ri'** durch die Anlage **1** transportiert wird. Wenn das Band **Fo** in der Transportrichtung **Ri"** durch die Anlage **1** transportiert wird, dient die Rolle **15"** zum Abwickeln des Bandes und die Rolle **15'** nach dem Spülen und Trocknen des Bandes **Fo** zum Aufwickeln.

Die Behandlungsanlage **1** umfaßt ferner einen Behälter **2**, in dem sich eine Behandlungsflüssigkeit **Fl** befindet. Das Band **Fo** wird nach Eintritt in den Behälter **2** über mehrere Umlenkrollen **3** geführt, die keine elektrische Funktion aufweisen, und wird dabei an einer Vielzahl von Elektrodenanordnungen, jeweils bestehend aus einer kathodisch gepolten Elektrode **6** und einer anodisch gepolten Elektrode **7**, vorbeigeführt. Die kathodisch gepolten Elektroden **6** sind mit "⊖" und die anodisch gepolten Elektroden **7** mit "⊕" bezeichnet. Im vorliegenden Fall sind die Elektrodenanordnungen nur an einer Oberfläche des Bandes **Fo** angeordnet. Falls beide Oberflächen bes Bandes **Fo** behandelt werden sollen, müssen sich Elektrodenanordnungen auf beiden Seiten des isolierenden Bandes befinden.

In einem Detail in **Fig. 12** ist ein Ausschnitt aus einer Elektrodenanordnung mit dem an dieser vorbeigeführten Band **Fo** gezeigt. Die kathodisch gepolte Elektrode **6** ist von der anodisch gepolten Elektrode **7** durch eine Isolierwand **9** getrennt.

### Bezugszeichen:

- **1**: Behandlungsanlage
- **2**: Badbehälter
- **3**: Führungselement für das Folienmaterial **Fo**
- **4**: metallische Struktur auf dem Folienmaterial **Fo**
- **4***: behandelte metallische Struktur **4**
- **4***_{**a**}: anodisch behandelte metallische Struktur **4**
- **4***_{**k**}: kathodisch behandelte metallische Struktur **4**
- **5**: Diaphragma
- **6,6',6",6'''**: kathodisch gepolte Elektroden
- **7,7',7",7'''**: anodisch gepolte Elektroden
- **8,8',8"**: Strom/Spannungsquellen
- **9**: Isolierwand
- **10**: Kathodenraum
- 11: Anodenraum
- **12**: Öffnung der Elektrodenanordnung zum Badbehälter
- **12**_{**k**}: Öffnung an der kathodisch gepolten Elektrode
- **12**_{**a**}: Öffnung an der anodisch gepolten Elektrode
- **13**: isolierende Seitenwand der Elektrodenanordnung
- **14**: isolierende Seitenwand der Elektrodenanordnung
- **15',15"**: Speicherrollen zum Auf-/Abwickeln von Folienbändern **Fo**
- **16**: Dichtfolie
- **17**: Isolierwand zwischen zwei Elektrodenanordnungen
- **18**: Elektrodenanordnung
- 20: Elektrolytleitung
- 21: Pumpe
- **22**: Filter
- **23**: Luftzuleitung
- **24**: Einlauföffnung
- **25**: Abquetschwalze
- **26**: Abquetschwalze
- **27**: Auslauföffnung
- **28**: Isolierwalze
- **29**: Opferbereich
- **30**: strukturierter Bereich
- **Fo**: Platten-/Folienmaterialstück
- **Ri,Ri',Ri"**: Transportrichtung
- **Fl**: Behandlungsflüssigkeit
- **Sr**: Strömungsrichtung der Behandlungsflüssigkeit **Fl**

## Patentansprüche

1. Verfahren zum elektrolytischen Behandeln von elektrisch gegeneinander isolierten, elektrisch leitfähigen Strukturen **(4)** auf Oberflächen von elektrisch isolierendem Folienmaterial **(Fo),** bei dem das Folienmaterial **(Fo)**
a. von einem Speicher **(15',15")** entladen wird;
b. dann auf einer Transportbahn durch eine Behandlungsanlage **(1)** transportiert und dabei mit Behandlungsflüssigkeit **(Fl)** in Kontakt gebracht wird;
c. während des Transportes an mindestens einer Elektrodenanordnung, jeweils bestehend aus mindestens einer kathodisch gepolten Elektrode **(6)** und mindestens einer anodisch gepolten Elektrode **(7),** vorbeigeführt wird, wobei die mindestens eine kathodisch gepolte Elektrode **(6)** und die mindestens eine anodisch gepolte Elektrode **(7)** mit der Behandlungsflüssigkeit **(Fl)** in Kontakt gebracht und mit einer Strom/Spannungsquelle **(8)** verbunden werden, so daß ein Strom durch die Elektroden **(6,7)** und die elektrisch leitfähigen Strukturen **(4)** fließt, wobei ferner die Elektroden **(6,7)** einer Elektrodenanordnung derart angeordnet werden, daß sie auf eine Seite des Materials **(Fo)** ausgerichtet sind, und wobei zwischen den Elektroden **(6,7)** mindestens eine Isolierwand **(9)** angeordnet wird; und
d. schließlich wieder auf einen Speicher **(15',15")** geladen wird.

2. Verfahren nach Anspruch 1, **dadurch gekennzeichnet, daß** die mindestens eine Isolierwand **(9)** derart angeordnet wird, daß sie das Material **(Fo)** beim Transport durch die Behandlungsanlage **(1)** berührt oder daß sie zumindest unmittelbar an das Material **(Fo)** heranreicht.

3. Verfahren nach einem der vorstehenden Ansprüche, **dadurch gekennzeichnet, daß** das Material **(Fo)** nacheinander an mindestens zwei Elektrodenanordnungen vorbeigeführt wird.

4. Verfahren nach einem der vorstehenden Ansprüche, **dadurch gekennzeichnet, daß** die Elektroden **(6,7)** langgestreckt ausgebildet und im wesentlichen parallel zu einer Fläche angeordnet werden, in der das Material **(Fo)** transportiert wird.

5. Verfahren nach Anspruch 4, **dadurch gekennzeichnet, daß** sich die Elektroden **(6,7)** etwa über die gesamte Breite des Materials **(Fo)** und im wesentlichen senkrecht zu der Richtung **(Ri)** erstrecken, in der das Material **(Fo)** transportiert wird.

6. Verfahren nach Anspruch 4, **dadurch gekennzeichnet, daß** die Elektroden **(6,7)** einen Winkel α ≠ 90° mit der Richtung **(Ri)** bilden, in der das Material **(Fo)** transportiert wird.

7. Verfahren nach einem der vorstehenden Ansprüche, **dadurch gekennzeichnet, daß** das Material **(Fo)** an mindestens zwei Elektrodenanordnungen mit langgestreckt ausgebildeten Elektroden **(6,7)** vorbeigeführt wird, wobei die Elektroden **(6,7)** unterschiedlicher Elektrodenanordnungen unterschiedliche Winkel mit der Richtung **(Ri)** bilden, in der das Material **(Fo)** transportiert wird.

8. Verfahren nach einem der vorstehenden Ansprüche, **dadurch gekennzeichnet, daß** die Elektroden **(6,7)** im wesentlichen parallel zu der Fläche oszillierend bewegt werden, in der das Material **(Fo)** transportiert wird.

9. Verfahren nach einem der vorstehenden Ansprüche, **dadurch gekennzeichnet, daß** die Elektrodenanordnungen von Isolierwänden **(13,14)** umgeben werden, zu den Oberflächen des Materials **(Fo)** ausgerichtete Öffnungen **(12**_{**k**}**,12**_{**a**}**)** an den Elektrodenanordnungen durch die Isolierwände **(13,14)** und zwischen den Elektroden **(6,7)** angeordnete Isolierwände **(9)** gebildet werden und daß diese Öffnungen **(12**_{**k**}**,12**_{**a**}**)** in Transportrichtung **(Ri)** gesehen jeweils eine derartige Weite aufweisen, daß die den kathodisch gepolten Elektroden **(6)** zugeordneten Öffnungen **(12**_{**k**}**)** kleiner sind als die den anodisch gepolten Elektroden **(7)** zugeordneten Öffnungen **(12**_{**a**}**)**, wenn das Verfahren zum Abscheiden von Metall auf dem Material (**Fo**) angewendet wird, oder daß die den kathodisch gepolten Elektroden **(6)** zugeordneten Öffnungen **(12**_{**k**}**)** größer sind als die den anodisch gepolten Elektroden **(7)** zugeordneten Öffnungen **(12**_{**a**}**)**, wenn das Verfahren zum Ätzen von Metalloberflächen **(4)** auf dem Material **(Fo)** angewendet wird.

10. Verfahren nach einem der vorstehenden Ansprüche, **dadurch gekennzeichnet, daß** mehrere parallel zueinander angeordnete, benachbarte Elektrodenanordnungen mit langgestreckt ausgebildeten Elektroden **(6,7)** vorgesehen und zueinander benachbarte Elektroden **(6,7)** mit jeweils einer Strom/Spannungsquelle **(8)** verbunden werden.

11. Verfahren nach Anspruch 10, **dadurch gekennzeichnet, daß** die Stromdichte an den der ersten Elektrodenanordnung gegenüberliegenden Strukturen **(4)** etwa doppelt so groß eingestellt wird wie die Stromdichte an den der zweiten Elektrodenanordnung gegenüberliegenden Strukturen **(4).**

12. Verfahren nach einem der vorstehenden Ansprüche, **dadurch gekennzeichnet, daß** Elektrolyträume **(10),** die die kathodisch gepolten Elektroden **(6)** umgeben, von ionensensitiven Membranen **(5)** abgeschirmt werden.

13. Verfahren nach einem der vorstehenden Ansprüche, **dadurch gekennzeichnet, daß** der elektrische Strom derart moduliert wird, daß eine unipolare oder bipolare Strompulsfolge durch die Elektroden **(6,7)** und die Oberflächen **(4)** des Materials **(Fo)** fließt.

14. Anwendung des Verfahrens nach einem der Ansprüche 1 bis 13 zum Abscheiden von Metall auf dem Folienmaterial (**Fo**), wobei das Material (**Fo**) zuerst an mindestens einer kathodisch gepolten (**6**) und danach an mindestens einer anodisch gepolten Elektrode **(7)** vorbeigeführt wird.

15. Anwendung nach Anspruch 14 zum Abscheiden von Zinn auf Kupferoberflächen **(4)** auf dem Material **(Fo)**.

16. Anwendung des Verfahrens nach einem der Ansprüche 1 bis 13 zum Ätzen von Metalloberflächen **(4)** auf dem Material **(Fo),** wobei das Material **(Fo)** zuerst an mindestens einer anodisch gepolten **(7)** und danach an mindestens einer kathodisch gepolten Elektrode **(6)** vorbeigeführt wird.

17. Vorrichtung zum elektrolytischen Behandeln von elektrisch gegeneinander isolierten, elektrisch leitfähigen Strukturen **(4)** auf Oberflächen von elektrisch isolierendem Folienmaterial **(Fo),** die folgende Merkmale aufweist:
a. je mindestens eine erste und zweite Einrichtung **(15',15")** zum Speichern des Folienmaterials **(Fo)**;
b. geeignete Transportorgane **(3)** für den Transport des Folienmaterials **(Fo)** auf einer Transportbahn durch eine Behandlungsanlage **(1)** von der mindestens einen ersten Speichereinrichtung **(15',15")** zu der mindestens einen zweiten Speichereinrichtung **(15',15")** für das Folienmaterial **(Fo)**;
c. mindestens eine Einrichtung zum In-Kontakt-Bringen des Folienmaterials **(Fo)** mit einer Behandlungsflüssigkeit **(Fl);**
d. mindestens eine Elektrodenanordnung, jeweils bestehend aus mindestens einer kathodisch gepolten Elektrode **(6)** und mindestens einer anodisch gepolten Elektrode **(7),** wobei die mindestens eine kathodisch gepolte Elektrode **(6)** und die mindestens eine anodisch gepolte Elektrode **(7)** mit der Behandlungsflüssigkeit **(Fl)** in Kontakt bringbar sind, wobei die kathodisch gepolten Elektroden **(6)** und die anodisch gepolten Elektroden (7) einer Elektrodenanordnung auf eine Seite der Transportbahn ausgerichtet sind;
e. mindestens eine Isolierwand **(9)** zwischen den Elektroden **(6,7)** jeweils einer Elektrodenanordnung; und
f. mindestens eine Strom/Spannungsquelle **(8),** die mit den Elektrodenanordnungen verbunden ist, zur Erzeugung eines Stromflusses durch die Elektroden **(6,7)** der Elektrodenanordnungen;
g. wobei die Elektroden **(6,7)** durch die mindestens eine Isolierwand derart gegeneinander abgeschirmt sind, daß im wesentlichen kein etektrischer Strom direkt zwischen gegensinnig gepolten Elektroden **(6,7)** fließen kann.

18. Vorrichtung nach Anspruch 17, **dadurch gekennzeichnet, daß** die mindestens eine Isolierwand **(9)** derart angeordnet ist, daß sie das Material **(Fo)** während des Transportes durch die Behandlungsanlage **(1)** berührt oder daß sie zumindest unmittelbar an das Material (**Fo**) heranreicht.

19. Vorrichtung nach einem der Ansprüche 17 und 18, **dadurch gekennzeichnet, daß** die Elektroden **(6,7)** langgestreckt ausgebildet und im wesentlichen parallel zu einer Fläche angeordnet sind, in der das Material **(Fo)** transportiert wird.

20. Vorrichtung nach Anspruch 19, **dadurch gekennzeichnet, daß** sich die Elektroden **(6,7)** im wesentlichen senkrecht zu der Richtung **(Ri)** erstrecken, in der das Material **(Fo)** transportiert wird.

21. Vorrichtung nach Anspruch 19, **dadurch gekennzeichnet, daß** die Elektroden **(6,7)** einen Winkel α ≠ 90° mit der Richtung **(Ri)** bilden, in der das Material **(Fo)** transportiert wird.

22. Vorrichtung nach einem der Ansprüche 17 bis 21, **dadurch gekennzeichnet, daß** mindestens zwei Elektrodenanordnungen mit langgestreckt ausgebildeten Elektroden (**6**,**7**) vorgesehen sind, wobei die Elektroden (**6,7**) unterschiedlicher Elektrodenanordnungen unterschiedliche Winkel mit der Richtung (**Ri**) bilden, in der das Material **(Fo)** transportiert wird.

23. Vorrichtung nach einem der Ansprüche 19 bis 22, **dadurch gekennzeichnet, daß** die langgestreckten Elektroden **(6,7)** derart ausgebildet sind, daß sie im wesentlichen parallel zu der Fläche oszillierend bewegbar sind, in der das Material **(Fo)** transportiert wird.

24. Vorrichtung nach einem der Ansprüche 17 bis 23, **dadurch gekennzeichnet, daß** die Elektrodenanordnungen von Isolierwänden **(13,14)** umgeben sind, zu der Fläche hin ausgerichtete Öffnungen **(12**_{**k**}**,12**_{**a**}**)** an den Elektrodenanordnungen durch die Isolierwände **(13,14)** und zwischen den Elektroden **(6,7)** angeordnete Isolierwände **(9)** gebildet sind, in der das Material **(Fo)** transportiert wird, und daß diese Öffnungen **(12**_{**k**}**,12**_{**a**}**)** in Transportrichtung **(Ri)** gesehen jeweils eine derartige Weite aufweisen, daß die den kathodisch gepolten Elektroden **(6)** zugeordneten Öffnungen **(12**_{**k**}**)** kleiner sind als die den anodisch gepotten Elektroden **(7)** zugeordneten Öffnungen **(12**_{**a**}**)**, wenn die Vorrichtung zum Abscheiden von Metall auf dem Material (Fo) verwendet wird, oder daß die den kathodisch gepolten Elektroden (**6**) zugeordneten Öffnungen **(12**_{**k**}**)** größer sind als die den anodisch gepolten Elektroden **(7)** zugeordneten Öffnungen **(12**_{**a**}**)**, wenn die Vorrichtung zum Ätzen von Metalloberflächen **(4)** des Materials **(Fo)** verwendet wird.

25. Vorrichtung nach einem der Ansprüche 17 bis 24, **dadurch gekennzeichnet, daß** Elektrolyträume **(10),** die die kathodisch gepolten Elektroden **(6)** umgeben, durch ionensensitive Membranen **(5)** abgeschirmt sind.

26. Vorrichtung nach einem der Ansprüche 17 bis 25, **dadurch gekennzeichnet, daß** mehrere parallel zueinander angeordnete, benachbarte Elektrodenanordnungen mit langgestreckt ausgebildeten Elektroden **(6,7)** vorgesehen und zueinander benachbarte Elektroden (6,7) mit jeweils einer separaten Strom/Spannungsquelle (8) verbunden sind.

## Claims

1. Method for the electrolytic treatment of electrically conductive structures (4) which are electrically insulated from one another, on surfaces of electrically insulating film material (Fo) in which the film material (Fo)
a. is discharged from a storage device (15', 15'');
b. is then conveyed on a conveyor path through a processing plant (1) and thereby brought into contact with treatment fluid (Fl);
c. as it is conveyed past at least one electrode arrangement, in each case comprising at least one cathodically polarised electrode (6) and at least one anodically polarised electrode (7), the at least one cathodically polarised electrode (6) and the at least one anodically polarised electrode (7) being brought into contact with the treatment fluid (Fl) and being connected to a current/voltage source (8), such that a current flows through the electrodes (6, 7) and the electrically conductive structures (4), the electrodes (6, 7) of an electrode arrangement being furthermore so arranged that they are oriented towards one side of the material (Fo), and at least one insulating wall (9) being arranged between the electrodes (6, 7); and
d. finally the film material is loaded again onto a storage device (15', 15'').

2. Method according to claim 1, **characterised in that** the at least one insulating wall (9) is arranged in such a way that it touches the material (Fo) as it is conveyed through the processing plant (1) or that it at least extends directly to the material (Fo).

3. Method according to one of the preceding claims, **characterised in that** the material (Fo) is led in succession past at least two electrode arrangements.

4. Method according to one of the preceding claims, **characterised in that** the electrodes (6, 7) are configured elongate and are arranged substantially parallel to a plane in which the material (Fo) is conveyed.

5. Method according to claim 4, **characterised in that** the electrodes (6, 7) extend roughly over the entire width of the material (Fo) and substantially perpendicularly with respect to the direction (Ri) in which the material (Fo) is conveyed.

6. Method according to claim 4, **characterised in that** the electrodes (6, 7) form an angle α ≠ 90° with the direction (Ri) in which the material (Fo) is conveyed.

7. Method according to one of the preceding claims, **characterised in that** the material (Fo) is led past at least two electrode arrangements which have elongate electrodes (6, 7), the electrodes (6, 7) of different electrode arrangements forming differing angles with the direction (Ri) in which the material (Fo) is conveyed.

8. Method according to one of the preceding claims, **characterised in that** the electrodes (6, 7) are moved oscillating substantially parallel to the plane in which the material (Fo) is conveyed.

9. Method according to one of the preceding claims, **characterised in that** the electrode arrangements are surrounded by insulating walls (13, 14) openings (12ₖ, 12ₐ), which are oriented towards the surfaces of the material (Fo), are formed on the electrode arrangements by the insulating walls (13, 14), and insulating walls (9) are arranged between the electrodes (6, 7), and **in that** these openings (12ₖ, 12ₐ), when viewed in the direction of conveyance (Ri), each have such a width that the openings (12ₖ) associated with the cathodically polarised electrodes (6) are smaller than the openings (12ₐ) associated with the anodically polarised electrodes, when the method is used for depositing metal on the material (Fo), or that the openings (12ₖ) associated with the cathodically polarised electrodes (6) are larger than the openings (12ₐ) associated with the anodically polarised electrodes (7) when the method is used for etching metal surfaces (4) on the material (Fo).

10. Method according to one of the preceding claims, **characterised in that** a plurality of adjacent electrode arrangements is provided which have elongate electrodes (6, 7) and are arranged parallel to one another, and electrodes (6, 7) which are adjacent to one another are each connected to a current/voltage source (8).

11. Method according to claim 10, **characterised in that** the current density at the structures (4) facing the first electrode arrangement is set to be roughly twice as high as the current density at the structures (4) facing the second electrode arrangement.

12. Method according to one of the preceding claims, **characterised in that** electrolyte chambers (10) which surround the cathodically polarised electrodes (6) are shielded by ion-selective membranes (5).

13. Method according to one of the preceding claims, **characterised in that** the electric current is modulated in such a way that a unipolar or bipolar current pulse sequence flows through the electrodes (6, 7) and the surfaces (4) of the material (Fo).

14. Application of the method according to one of claims 1 to 13 for depositing metal on the film material (Fo), the material (Fo) being led first past at least one cathodically polarised electrode (6) and thereafter past at least one anodically polarised electrode (7).

15. Application according to claim 14 for depositing tin on copper surfaces (4) on the material (Fo) .

16. Application of the method according to one of claims 1 to 13 for etching metal surfaces (4) on the material (Fo), the material (Fo) being first led past at least one anodically polarised electrode (7) and thereafter past at least one cathodically polarised electrode (6).

17. Apparatus for the electrolytic treatment of electrically conductive structures (4) which are electrically insulated from one another, on surfaces of electrically insulating film material (Fo), which apparatus has the following features:
a. each at least one first and one second device (15', 15'') for storing the film material (Fo);
b. suitable conveying members (3) for conveying the film material (Fo) on a conveyor path through a processing plant (1) from the at least one first storage device (15', 15'') to the at least one second storage device (15', 15'') for the film material (Fo);
c. at least one device for bringing the film material (Fo) into contact with a treatment fluid (Fl);
d. at least one electrode arrangement, in each case comprising at least one cathodically polarised electrode (6) and at least one anodically polarised electrode (7), the at least one cathodically polarised electrode (6) and the at least one anodically polarised electrode (7) being able to be brought into contact with the treatment fluid (Fl), the cathodically polarised electrodes (6) and the anodically polarised electrodes (7) of an electrode arrangement being oriented towards one side of the conveyor path;
e. at least one insulating wall (9) between the electrodes (6, 7) of each electrode arrangement; and
f. at least one current/voltage source (8) which is connected to the electrode arrangements, to generate a current flow through the electrodes (6, 7) of the electrode arrangements;
g. the electrodes (6, 7) being shielded from one another by the at least one insulating wall in such a way that substantially no electric current can flow directly between oppositely polarised electrodes (6, 7).

18. Apparatus according to claim 17, **characterised in that** the at least one insulating wall (9) is arranged in such a way that it touches the material (Fo) as it is conveyed through the processing plant (1) or that it extends at least directly to the material (Fo).

19. Apparatus according to one of claims 17 and 18, **characterised in that** the electrodes (6, 7) are configured elongate and are arranged substantially parallel to a plane in which the material (Fo) is conveyed.

20. Apparatus according to claim 19, **characterised in that** the electrodes (6, 7) extend substantially perpendicularly with respect to the direction (Ri) in which the material (Fo) is conveyed.

21. Apparatus according to claim 19, **characterised in that** the electrodes (6, 7) form an angle α ≠ 90° with the direction (Ri) in which the material (Fo) is conveyed.

22. Apparatus according to one of claims 17 to 21, **characterised in that** at least two electrode arrangements which have elongate electrodes (6, 7) are provided, the electrodes (6, 7) of different electrode arrangements forming differing angles with the direction (Ri) in which the material (Fo) is conveyed.

23. Apparatus according to one of claims 19 to 22, **characterised in that** the elongate electrodes (6, 7) are so configured that they can be moved oscillating substantially parallel to the plane in which the material (Fo) is transported.

24. Apparatus according to one of claims 17 to 23, **characterised in that** the electrode arrangements are surrounded by insulating walls (13, 14), openings (12ₖ, 12ₐ), which are oriented towards the plane in which the material (Fo) is conveyed, are formed on the electrode arrangements by the insulating walls (13, 14), and insulating walls (9) being formed between the electrodes (6, 7), and **in that** these openings (12ₖ, 12ₐ), when viewed in the direction of conveyance (Ri), each have such a width that the openings (12ₖ) associated with the cathodically polarised electrodes (6) are smaller than the openings (12ₐ) associated with the anodically polarised electrodes, when the apparatus is used for depositing metal on the material (Fo), or that the openings (12ₖ) associated with the cathodically polarised electrodes (6) are larger than the openings (12ₐ) associated with the anodically polarised electrodes (7) when the apparatus is used for etching metal surfaces (4) of the material (Fo).

25. Apparatus according to one of claims 17 to 24, **characterised in that** electrolyte chambers (10) which surround the cathodically polarised electrodes (6) are shielded by ion-selective membranes (5).

26. Apparatus according to one of claims 17 to 25, **characterised in that** a plurality of adjacent electrode arrangements is provided which have elongate electrodes (6, 7) and are arranged parallel to one another, and electrodes (6, 7) which are adjacent to one another are each connected to a separate current/voltage source (8) .

## Revendications

1. Procédé de traitement électrolytique de structures (4) électroconductrices isolées les unes par rapport aux autres sur des surfaces de matériau en feuille (Fo) isolant électrique, pour lequel le matériau en feuille (Fo)
a. est déchargé d'un dispositif de stockage (15', 15");
b. est ensuite transporté sur une piste de transport à travers une installation de traitement (1) et est amené ce faisant en contact avec un liquide de traitement (Fl);
c. est amené pendant le transport au voisinage d'au moins une disposition d'électrodes, consistant respectivement en au moins une électrode polarisée comme cathode (6) et au moins une électrode polarisée comme anode (7), sachant que la au moins une électrode polarisée comme cathode (6) et la au moins une électrode polarisée comme anode (7) sont mises en contact avec le liquide de traitement (Fl) et sont reliées à une source de courant et de tension (8), de telle sorte qu'un courant s'écoule par les électrodes (6, 7) et les structures électroconductrices (4), sachant en outre que les électrodes (6, 7) d'une disposition d'électrodes sont disposées de telle sorte qu'elles sont orientées sur une face du matériau (Fo) et sachant qu'entre les électrodes (6, 7) est disposée au moins une paroi isolante (9) ; et
d. est finalement rechargée sur un dispositif de stockage (15', 15").

2. Procédé selon la revendication 1, **caractérisé en ce que** la au moins une paroi isolante (9) est disposée de telle sorte qu'elle touche le matériau (Fo) lors du transport à travers l'installation de traitement (1) ou qu'elle s'approche au moins tout près du matériau (Fo).

3. Procédé selon l'une quelconque des revendications précédentes, **caractérisé en ce que** le matériau (Fo) est conduit au voisinage d'au moins deux dispositions d'électrodes l'une après l'autre.

4. Procédé selon l'une quelconque des revendications précédentes, **caractérisé en ce que** les électrodes (6, 7) sont configurées étendues en longueur et sont disposées essentiellement parallèlement à une surface dans laquelle le matériau (Fo) est transporté.

5. Procédé selon la revendication 4, **caractérisé en ce que** les électrodes (6, 7) s'étendent à peu près sur le total de la largeur du matériau (Fo) et essentiellement perpendiculairement à la direction (Ri) dans laquelle le matériau (Fo) est transporté.

6. Procédé selon la revendication 4, **caractérisé en ce que** les électrodes (6, 7) forment un angle α ≠ 90° avec la direction (Ri) dans laquelle est transporté le matériau (Fo).

7. Procédé selon l'une quelconque des revendications précédentes, **caractérisé en ce que** le matériau (Fo) est amené au voisinage d'au moins deux dispositions d'électrodes avec des électrodes (6, 7) configurées étendues en longueur, sachant que les électrodes (6, 7) de différentes dispositions d'électrodes forment différents angles avec la direction (Ri) dans laquelle est transporté le matériau (Fo).

8. Procédé selon l'une quelconque des revendications précédentes, **caractérisé en ce que** les électrodes (6, 7) sont déplacées de façon oscillante essentiellement parallèlement à la surface dans laquelle le matériau (Fo) est transporté.

9. Procédé selon l'une quelconque des revendications précédentes, **caractérisé en ce que** les dispositions d'électrodes sont entourées de parois isolantes (13, 14), **en ce que** des ouvertures (12k, 12a), orientées vers les surfaces du matériau (Fo), sont formées par les parois isolantes (13, 14) au niveau des dispositions d'électrodes et des parois isolantes (9) disposées entre les électrodes (6, 7) sont formées, et **en ce que** ces ouvertures (12k, 12a), vues dans la direction du transport (Ri), présentent chacune une largeur telle que les ouvertures (12k) rapportées aux électrodes polarisées comme cathodes (6) sont plus petites que les ouvertures (12a) rapportées aux électrodes polarisées comme anodes (7) quand le procédé est appliqué pour le dépôt d'un métal sur le matériau (Fo), ou que les ouvertures (12k) rapportées aux électrodes polarisées comme cathodes (6) sont plus grandes que les ouvertures (12a) rapportées aux électrodes polarisées comme anodes (7), quand le procédé est appliqué pour la gravure chimique de surfaces de métal (4) sur le matériau (Fo).

10. Procédé selon l'une quelconque des revendications précédentes, **caractérisé en ce que** plusieurs dispositions d'électrodes voisines sont prévues, disposées parallèlement les unes aux autres avec des électrodes (6, 7) configurées étendues en longueur, et **en ce que** les électrodes (6, 7) voisines les unes des autres sont reliées respectivement à une source de courant et de tension (8).

11. Procédé selon la revendication 10, **caractérisé en ce que**, sur les structures (4) se trouvant en face de la première disposition d'électrode, on règle la densité de courant à peu près au double de la densité de courant sur les structures (4) se trouvant en face de la deuxième disposition d'électrode.

12. Procédé selon l'une quelconque des revendications précédentes, **caractérisé en ce que** les espaces remplis d'électrolyte (10) qui entourent les électrodes polarisées comme cathodes (6) sont isolés par des membranes sensibles aux ions (5).

13. Procédé selon l'une quelconque des revendications précédentes, **caractérisé en ce que** le courant électrique est modulé de telle sorte qu'une suite de pulsations de courant unipolaire ou bipolaire s'écoule à travers les électrodes (6, 7) et les surfaces (4) du matériau (Fo).

14. Application du procédé selon l'une quelconque des revendications 1 à 13 pour le dépôt de métal sur le matériau en feuille (Fo), dans laquelle le matériau (Fo) est d'abord amené au voisinage d'au moins une électrode polarisée comme cathode (6), et ensuite au voisinage d'au moins une électrode polarisée comme anode (7).

15. Application selon la revendication 14 pour déposer de l'étain sur des surfaces de cuivre (4) sur le matériau (Fo).

16. Application du procédé selon l'une quelconque des revendications 1 à 13 pour graver des surfaces métalliques (4) sur le matériau (Fo), dans laquelle le matériau (Fo) est d'abord amené au voisinage d'au moins une électrode polarisée comme anode (7), et ensuite au voisinage d'au moins une électrode polarisée comme cathode (6).

17. Dispositif pour le traitement électrolytique de structures (4) électroconductrices isolées les unes par rapport aux autres sur des surfaces de matériau en feuille (Fo) isolant électrique, qui présente les propriétés suivantes :
a. au moins un premier et un deuxième dispositif (15', 15") pour le stockage du matériau en feuille (Fo);
b. des organes de transport appropriés (3) pour le transport du matériau en feuille (Fo) sur une piste de transport à travers une installation de traitement (1) depuis le au moins un premier dispositif de stockage (15', 15") jusqu'au au moins un deuxième dispositif de stockage (15', 15") pour le matériau en feuille (Fo) ;
c. au moins un dispositif pour la mise en contact du matériau en feuille (Fo) avec le liquide de traitement (Fl);
d. au moins une disposition d'électrodes, consistant respectivement en au moins une électrode polarisée comme cathode (6) et au moins une électrode polarisée comme anode (7), sachant que la au moins une électrode polarisée comme cathode (6) et la au moins une électrode polarisée comme anode (7) peuvent être mises en contact avec le liquide de traitement (Fl), sachant que les électrodes polarisées comme cathodes (6) et les électrodes polarisées comme anodes (7) d'une disposition d'électrodes sont orientées d'un côté de la piste de transport ;
e. au moins une paroi isolante (9) entre les électrodes (6, 7) d'une disposition d'électrodes respectivement ; et
f. au moins une source de courant et de tension (8), qui est reliée aux dispositions d'électrodes, pour la génération de l'écoulement d'un courant à travers les électrodes (6, 7) des dispositions d'électrodes ;
g. sachant que les électrodes (6, 7) sont isolées les unes des autres par la au moins une paroi isolante de telle sorte que, pour l'essentiel, aucun courant électrique ne peut s'écouler directement entre des électrodes (6, 7) de polarité opposée.

18. Dispositif selon la revendication 17, **caractérisé en ce que** la au moins une paroi isolante (9) est disposée de telle sorte qu'elle touche le matériau (Fo) lors du transport à travers l'installation de traitement (1) ou qu'elle s'approche au moins tout près du matériau (Fo).

19. Dispositif selon l'une quelconque des revendications 17 ou 18, **caractérisé en ce que** les électrodes (6, 7) sont configurées étendues en longueur et sont disposées essentiellement parallèlement à une surface dans laquelle le matériau (Fo) est transporté.

20. Dispositif selon la revendication 19, **caractérisé en ce que** les électrodes (6, 7) s'étendent essentiellement perpendiculairement à la direction (Ri) dans laquelle le matériau (Fo) est transporté.

21. Dispositif selon la revendication 19, **caractérisé en ce que** les électrodes (6, 7) forment un angle α ≠ 90° avec la direction (Ri) dans laquelle est transporté le matériau (Fo).

22. Dispositif selon l'une quelconque des revendications 17 à 21, **caractérisé en ce qu'**au moins deux dispositions d'électrodes sont prévues avec des électrodes (6, 7) configurées étendues en longueur, sachant que les électrodes (6, 7) de différentes dispositions d'électrodes forment différents angles avec la direction (Ri) dans laquelle est transporté le matériau (Fo).

23. Dispositif selon l'une quelconque des revendications 19 à 22, **caractérisé en ce que** les électrodes étendues en longueur (6, 7) sont configurées de telle sorte qu'elles peuvent être déplacées de façon oscillante essentiellement parallèlement à la surface dans laquelle le matériau (Fo) est transporté.

24. Dispositif selon l'une quelconque des revendications 17 à 23, **caractérisé en ce que** les dispositions d'électrodes sont entourées de parois isolantes (13, 14), **en ce que** des ouvertures (12k, 12a), orientées vers la surface dans laquelle le matériau en feuille (Fo) est transporté sont formées par les parois isolantes (13, 14) au niveau des dispositions d'électrodes et des parois isolantes (9) disposées entre les électrodes (6, 7) sont formées, et **en ce que** ces ouvertures (12k, 12a), vues dans la direction du transport (Ri), présentent chacune une largeur telle que les ouvertures (12k) rapportées aux électrodes polarisées comme cathodes (6) sont plus petites que les ouvertures (12a) rapportées aux électrodes polarisées comme anodes (7) quand le dispositif est utilisé pour le dépôt d'un métal sur le matériau (Fo), ou que les ouvertures (12k) rapportées aux électrodes polarisées comme cathodes (6) sont plus grandes que les ouvertures (12a) rapportées aux électrodes polarisées comme anodes (7) quand le dispositif est utilisé pour la gravure chimique de surfaces métalliques (4) du matériau (Fo).

25. Dispositif selon l'une quelconque des revendications 17 à 24, **caractérisé en ce que** les espaces remplis d'électrolyte (10) qui entourent les électrodes polarisées comme cathodes (6) sont isolés par des membranes sensibles aux ions (5).

26. Dispositif selon l'une quelconque des revendications 17 à 25, **caractérisé en ce que** plusieurs dispositions d'électrodes voisines disposées parallèlement les unes aux autres avec des électrodes (6, 7) configurées étendues en longueur sont prévues et **en ce que** chacune des électrodes (6, 7) voisines l'une de l'autre est reliée respectivement à une source de courant et de tension (8) séparée.
